# EUROPÄISCHE PATENTSCHRIFT

(11) **EP 4 127 592 B1**
(45) Veröffentlichungstag und Bekanntmachung des Hinweises auf die Patenterteilung: **20.03.2024**
(21) Anmeldenummer: 21716095.1
(22) Anmeldetag: 25.03.2021
(51) Int. Cl.: F28F 1/02, F28F 1/40, F28F 3/12, F28F 9/02, F28F 13/14, H01L 23/473, H05K 7/20

(54) **TEMPERIERKÖRPERGEHÄUSE, TEMPERIERANORDNUNG, ELEKTRISCHE VORRICHTUNG UND VERWENDEN DERSELBEN**
CASING OF TEMPERATURE-CONTROL BODY, TEMPERATURE-CONTROL ARRANGEMENT, ELECTRICAL DEVICE AND ITS USE
BOÎTIER D'UN CORPS DE THERMORÉGULATION, ENSEMBLE DE THERMORÉGULATION, DISPOSITIF ÉLECTRIQUE ET SON UTILISATION

(30) Priorität: 03.04.2020 DE 102020109368
(43) Veröffentlichungstag der Anmeldung: 08.02.2023
(73) Patentinhaber: WAIYS GmbH, 01099 Dresden (DE)
(72) Erfinder: STRUCKMEIER, Jens, 01277 Dresden (DE); BUDER, Ricardo, 01127 Dresden (DE); PAMPEL, Stephan, 01097 Dresden (DE); FRIEDENSTAB, Lukas, 01099 Dresden (DE); STEINIGEN, Martin, 01099 Dresden (DE); PUDER, Holm, 09599 Freiberg (DE); WÄCHTER, Conrad, 01099 Dresden (DE)
(74) Vertreter: Viering, Jentschura & Partner mbB Patent- und Rechtsanwälte
(86) Internationale Anmeldenummer: PCT/EP2021/057664
(87) Internationale Veröffentlichungsnummer: WO 2021/197989

(56) Entgegenhaltungen:
- EP-A1- 2 388 852
- EP-A1- 3 429 023
- DE-A1-102016 125 859
- DE-A1-102018 128 016
- DE-B1- 2 916 799
- US-A1- 2011 127 007
- US-A1- 2014 151 010
- US-A1- 2014 231 057
- US-A1- 2018 356 161
- US-A1- 2019 056 179
- US-B1- 6 173 763

## Beschreibung

Die Erfindung betrifft ein Temperierkörpergehäuse, eine Temperieranordnung, eine elektrische Vorrichtung und das Verwenden derselben.

Der Wärmeübergang von einer Wärmequelle zum umgebenden Kühlmedium ist in erster Linie von der Temperaturdifferenz, der wirksamen Oberfläche und der Strömungsgeschwindigkeit des umgebenden Kühlmediums abhängig. Ein Kühlkörper hat die Aufgabe, diesen Vorgang zu begünstigen (z.B. verstärken) und Verlustwärme durch Wärmeleitung von der Wärmequelle wegzuleiten und diese dann durch Wärmestrahlung und Konvektion an die Umgebung abzugeben.

Der Einsatz herkömmlicher Kühlkörper lässt sich in zwei Kühltypen unterteilen, nämlich die aktive Kühlung und die passive Kühlung. Bei der aktiven Kühlung wird dem Kühlkörper mittels technischer Mittel ein Kühlfluid zugeführt.

Soll nicht unbedingt Umgebungsluft als Kühlfluid verwendet werden, wird häufig ein in-sich geschlossenes Kühlsystem bereitgestellt, in welchem das Kühlfluid zirkulieren kann.

Kühlkörper für ein solches in-sich geschlossenes Kühlsystem weisen herkömmlicherweise eine Kammer auf, durch welche das Kühlfluid, z.B. Wasser, hindurchgeleitet wird. Hierzu gibt es eine Vielzahl unterschiedlicher Bauformen und Konzepte, um die Kammer bereitzustellen. Je größer die Kühlleistung sein soll, umso komplexere Kammerformen sind erforderlich, um die Wärmeübergangsfläche und den konvektiven Wärmeübergang möglichst groß zu gestalten. Je komplexer die Kammerform ist, desto mehr Herstellungsschritte sind vonnöten, was die Herstellungskosten vergrößert. Herkömmlicherweise wird eine mäanderförmige Kammer in einen Kupferblock hineingefräst. Herkömmlicherweise werden mehrere Bohrungen in einem Kupferblock zu einer Kammer verbunden und müssen nachträglich wieder verschlossen werden.

DE 10 2016 125 859 A1 beschreibt einen Wärmetauscher mit einem monolithischen, metallischen Strangpressprofil als Kühlkörper und zugehörige nicht-metallische Anschlusskörper, die jeweils einen Anschluss aufweisen. US 2011 / 0 127 007 A1 beschreibt eine Kühlvorrichtung mit einem Hauptkörper und an dessen Ende angeordneten Adaptervorrichtungen, wobei der Hauptkörper Kanäle zum Kühlen aufweist. EP 2 388 852 A1 beschreibt eine Kühlvorrichtung zum Kühlen elektrischer Komponenten, die mehrere miteinander verbindbare Kühlkörper und an deren Ende einen Sammler aufweist. DE 29 16 799 B1 beschreibt einen einstückigen Wärmetauscher aus einem keramischen Werkstoff. US 2014 / 0 231 057 A1 beschreibt einen Wärmetauscher mit einem durch Extrudieren herstellbaren Hauptkörper. DE 10 2018 128 016 A1 beschreibt eine Kühlelement für eine Batterieanordnung, wobei das Kühlelement mehrere miteinander verbindbare Wärmetauscherplatten aufweist.

US 2018 / 0 356 161 A1 beschreibt einen Wärmetauscher mit monolithischem Mittenteil und Kappen-Baugruppen, die Anschluss aufweisen. EP 3 429 023 A1 und US 2019 / 0 056 179 A1 beschreiben jeweils einen Wärmetauscher. US 2014 / 0 151 010 A1 und US 6 173 763 B1 zeigen jeweils Wärmetauscher, die Rippen mit asymmetrischer Kontur aufweisen.

Aufgrund immer größerer Rechenzentren bzw. immer größeren Anzahl von Prozessoren (oder anderen zu kühlenden Bauteilen) wird auch die Anzahl der benötigten Kühlkörper immer größer. Daher werden Herstellungspreis, Kühlleistung, Materialverfügbarkeit, Umweltverträglichkeit, Zuverlässigkeit und Montageaufwand der Temperierkörper (z.B. Kühlkörper) zu immer wichtigeren ökonomischen und ökologischen Faktoren. Um dieser Entwicklung Rechnung zu tragen wird gemäß verschiedenen Ausführungsformen ein Temperierkörpergehäuse (z.B. Kühlkörpergehäuse) bereitgestellt, welches kostengünstig hergestellt werden kann, leicht zu montieren ist, eine hohe Temperierleistung (z.B. Kühlleistung) bereitstellt, wenig Bestandteile aufweist und damit weniger Dichtungen benötigt, und welches besonders robust ist.

Anschaulich wurde erkannt, dass diese Eigenschaften erreicht werden können, indem das Temperierkörpergehäuse in mehrere funktionelle Bestandteile unterteilt wird, die jeweils eine möglichst wenig komplexe Form aufweisen und kostengünstigen Herstellungsverfahren zugänglich sind. Das Temperierkörpergehäuse gemäß der Erfindung weist einen Gehäusemittelteil auf, welcher derart geformt ist, dass dieser monolithisch hergestellt werden kann. Dies reduziert die Anzahl an Komponenten und damit die Montagekosten sowie Dichtungsstellen. Der Gehäusemittelteil kann beispielsweise strangförmig sein. Dies ermöglicht es, den Gehäusemittelteil in großen Mengen schnell und günstig herzustellen und gleichzeitig eine große Wärmeübergangsfläche zu realisieren.

Das Temperierkörpergehäuse weist ferner zwei Endkappen (auch als Gehäuseendkappen oder Endstücken bezeichnet) auf, welche stirnseitig des Gehäusemittelteils aufgesetzt werden können, um eine geschlossene Kammer im Inneren bereitzustellen. Die Endkappen sind beispielsweise von dem Gehäusemittelteil separate Bestandteile, und können somit aus einem billigeren Material hergestellt werden, z.B. angepasst anherrschende Materialkosten. Dies erreicht eine große Flexibilität, um den Herstellungspreis zu minimieren, ohne den Gehäusemittelteil und damit die Temperierleistung (z.B. Kühlleistung) beeinflussen zu müssen. Ebenso können die Endkappen mit wenig Montageaufwand ausgetauscht werden. Die Endkappen können auch gemäß einer Vielzahl von Gegebenheiten in unterschiedlichen Typen vorgefertigt sein, so dass das Temperierkörpergehäuse mittels eines geeigneten Typs unkompliziert an die Einbausituation angepasst werden kann. Eine Kappenform als solche ist wenig komplex und kann daher in großen Mengen schnell und günstig hergestellt werden, z.B. aus einem leicht zu verarbeitenden Material, wie beispielsweise einem Kunststoff. Das Gehäusemittelteil gemäß verschiedenen Ausführungsformen weist ferner eine erste Temperierrippe auf, welche in den Fluidkanal hinein erstreckt ist und eine asymmetrische Kontur aufweist, und/oder weist zwei einander unmittelbar benachbarte Fluidkanäle und ferner eine zweite Temperierrippe, welche die zwei einander benachbarten Fluidkanäle voneinander separiert und eine asymmetrische Kontur aufweist, auf.

Es zeigen
- Figuren 1 bis 10, 11A und 21 bis 26 und 28: jeweils ein Temperierkörpergehäuse (z.B. Kühlkörpergehäuse) gemäß verschiedenen Ausführungsformen in verschiedenen Ansichten;
- Figur 11B: die Eigenschaften eines Temperierkörpergehäuses gemäß verschiedenen Ausführungsformen in einem schematischen Diagramm;
- Figur 12: eine Temperieranordnung gemäß verschiedenen Ausführungsformen in einer schematischen Seitenansicht oder Querschnittsansicht;
- Figur 13: eine elektrische Vorrichtung (z.B. einen oder mehr als einen Prozessor, einen oder mehr als einen Speicherbaustein (z.B. RAM), einen oder mehr als einen Mosfet, und/oder eine oder mehr als eine Spule aufweisend) gemäß verschiedenen Ausführungsformen in einer schematischen Seitenansicht oder Querschnittsansicht;
- Figuren 14A und 14B: jeweils ein Temperiermodul (z.B. Kühlanordnung/Kühlkörper) gemäß einem Vergleichsbeispiel in einer schematischen Perspektivansicht;
- Figuren 15A und 15B: jeweils dieselbe elektrische Vorrichtung gemäß einem Vergleichsbeispiel in verschiedenen schematischen Ansichten;
- Figuren 16A bis 20: jeweils ein Temperiermodul gemäß einem Vergleichsbeispiel in verschiedenen schematischen Ansichten, z.B. Fig. 16A bis 17B Detailansichten der Ausführungsformen gemäß Fig.15A und 15B; und
- Figur 27: ein Temperierkörpergehäuse (z.B. Kühlkörpergehäuse) gemäß einem Vergleichsbeispiel 2700 in einer schematischen Querschnittsansicht.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. fluidleitenden, d.h. einer fluidleitfähigen, Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung (z.B. ein Material) übertragen werden kann. Beispielsweise können zwei miteinander gekoppelte Elemente eine Wechselwirkung miteinander austauschen, z.B. eine mechanische, hydrostatische, thermische und/oder elektrische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Eine fluidleitende Verbindung bzw. Kopplung zwischen zwei Elementen kann ermöglichen, dass die zwei Elemente ein Fluid (d.h. ein flüssiger Stoff und/oder gasförmiger Stoff aufweisend oder daraus gebildet) miteinander austauschen können. Die fluidleitende Verbindung kann optional nach außen hin abgedichtet sein, so dass der Austausch des Fluids im Wesentlichen verlustfrei erfolgt. Beispielsweise kann somit ein Element der zwei Elemente zugeführtes Fluid mittels der fluidleitenden Verbindung dem anderen Element der zwei Elemente zuführen.

Hierin wird Bezug genommen auf den Vorgang des Tempierens eines Bauteils, z.B. indem dem Bauteil thermische Energie (auch als Wärme oder Wärmeenergie bezeichnet) entzogen wird (auch als Kühlen bezeichnet) und/oder thermische Energie zugeführt (auch als Heizen bezeichnet) wird. Das Tempieren kann aufweisen, dass aktiv, z.B. unter Aufwendung elektrischer Energie, ein Wärmefluss bereitgestellt zu dem Bauteil hin und/oder von diesem weg.

Verschiedene elektrische Bauelemente (auch als elektrische Bauteile bezeichnet) nehmen im Betrieb elektrische Leistung auf und wandeln diese teilweise oder vollständig in thermische Leistung um (auch als Wärmequelle oder elektrothermischer Wandler bezeichnet). Um die dabei frei werdende thermische Leistung abzuführen, wird üblicherweise ein sogenannter Temperierkörper eingesetzt. Der Temperierkörper kann beispielsweise von einem Fluid durchflossen oder umflossen sein, z.B. ein Gehäuse aufweisen, durch welches das Fluid hindurchströmt. Das Fluid kann eine geringere Temperatur aufweisen als das elektrische Bauelement, sodass ein kontinuierlicher Wärmestrom von dem elektrischen Bauelement zu dem Fluid hin bereitgestellt wird. Das Fluid kann die thermische Leistung aufnehmen und entlang der Strömungsrichtung abtransportieren. Dieser Prozess der Wärmeaufnahme mittels eines strömenden Fluids erreicht, dass eine hohe Leistung auf geringem Raum abtransportiert werden kann.

Wahlweise kann das Fluid kontinuierlich gegen neues Fluid ausgetauscht werden, so dass das Fluid selbst nicht temperiert (z.B. gekühlt) werden muss. Alternativ kann das Fluid wiederverwendet werden, z.B. zyklisch, indem das Fluid selbst temperiert (z.B. gekühlt) wird, so dass das temperierte (z.B. gekühlte) Fluid dem Temperierkörper wieder zugeführt wird (auch als Temperierkreislauf bezeichnet).

Wird dem elektrischen Bauelement mittels des Temperierkörpers thermische Leistung entzogen (auch als Kühlen bezeichnet), wird der Temperierkörper hierin als Kühlkörper, das Temperierkörpergehäuse als Kühlkörpergehäuse, das Fluid als Kühlfluid, bzw. der Fluidkanal als Kühlkanal bezeichnet. Wird dem elektrischen Bauelement mittels des Temperierkörpers thermische Leistung zugeführt (auch als Heizen bezeichnet), wird der Temperierkörper hierin als Heizkörper, das Temperierkörpergehäuse als Heizkörpergehäuse, das Fluid als Heizfluid, bzw. der Fluidkanal als Heizkanal bezeichnet. Hierin wird unter anderem auf ein Kühlkörpergehäuse als exemplarisches Temperierkörpergehäuse Bezug genommen. Es kann verstanden werden, dass das für das Kühlkörpergehäuse Beschriebe in Analogie für jede Art von Temperierkörpergehäuse gelten kann, z.B. für ein Heizkörpergehäuse.

Im Folgenden wird unter anderem Bezug genommen auf einen Prozessor als Beispiel für eine zu temperierende elektronische Komponente (elektronisches Bauteil). Das für den Prozessor Beschriebene kann in Analogie gelten für eine elektronische Komponente anderen Typs, z.B. einen Transistor (z.B. MOSFET, d.h. Metall-Oxid-Halbleiter-Feldeffekttransistor), z.B. einen Leistungstransistor, eine Spule, einen Speicherbaustein (z.B. RAM, d.h. Direktzugriffsspeicher) oder Ähnliches.

Gemäß verschiedenen Ausführungsformen wird eine Vorrichtung mit einem Kühlkörpergehäuse zum Kühlen von Elektronik (auch als elektrisches Bauelement oder Elektrobauteile bezeichnet) bereitgestellt. Beispiele für Elektrobauteile weisen auf: Server, Serversysteme, Netzwerktechnik, Kommunikationstechnik, Leistungselektronik, Wandlersysteme und Elektromotoren.

Der Begriff "monolithisch" im Zusammenhang mit einem Körper kann verstanden werden, als dass der Körper aus einem Stück gebildet ist, d.h. nicht gefügt ist oder anders ausgedrückt: frei ist von stoffschlüssigen Verbindungen oder anderen Fügungsstellen (wie Schweißnähten, Lötnähten oder Klebenähten). Ein monolithischer Körper kann im Ganzen gebildet sein, z.B. nur mittels Gießens, Trennens und/oder Umformens aber ohne ein Fügen, z.B. fügende Bearbeitungsschritte, d.h. ohne diesem Material hinzuzufügen. Ein monolithischer Körper kann eine im Wesentlichen einheitliche Materialzusammensetzung aufweisen, d.h. dass beliebige Abschnitte des Körpers aus demselben Material (z.B. in derselben chemischen Konfiguration) gebildet sind. Im Zusammenhang mit einem hohlen Körper (z.B. einem Gehäusemittelteil) kann "monolithisch" verstanden werden, als dass jeder Hohlraum (z.B. jeder Fluidkanal) des Körpers begrenzt wird von Wänden, die monolithischer Bestandteil des Körpers sind (d.h. auch untereinander monolithisch miteinander verbunden sind). Ein hohler Körper (auch als Hohlkörper bezeichnet) bezeichnet einen Körper, der einen oder mehr als einen Hohlraum aufweist.

Ein monolithischer Gehäusemittelteil kann beispielsweise zwei Fluidkanäle aufweisen, die an eine Kühlrippe (z.B. eine Kanalwand bereitstellend), die ein monolithischer Bestandteil des Gehäusemittelteils ist, angrenzen. Ein monolithischer Gehäusemittelteil kann beispielsweise eine Vielzahl Fluidkanäle aufweisen, welche paarweise an dieselbe Rippe angrenzen, die monolithischer Bestandteil des Gehäusemittelteils ist.

Jeder Fluidkanal des Gehäusemittelteils kann anschaulich auf vier Seiten vollständig mittels entsprechender Wände (auch als Kanalwände bezeichnet) begrenzt sein bzw. nur auf einander gegenüberliegenden Seiten des Gehäusemittelteils freigelegt sein. Die Kanalwände des monolithischen Gehäusemittelteils, welche den Fluidkanal auf den vier Seiten begrenzen, können monolithisch mit den Außenwänden des Gehäusemittelteils verbunden sein.

Ein monolithischer Gehäusemittelteil kann beispielsweise nur Oberflächen (z.B. die Oberflächen der Kanalwände und/oder der Außenwände des Gehäusemittelteils) aufweisen, welche miteinander monolithisch verbunden sind.

Ein monolithischer Gehäusemittelteil kann beispielsweise ein zusammenhängender Block sein, durch welchen hindurch ein oder mehr als ein Fluidkanal erstreckt ist. Der oder jeder Fluidkanal des Gehäusemittelteils kann beispielsweise entlang eines linearen Pfads durch den Gehäusemittelteil hindurch erstreckt sein.

Der Fluidkanal kann den Hohlraum bezeichnen, der das Fluid aufnimmt. Der Fluidkanal kann von Wänden begrenzt sein, welche in Kontakt mit dem Fluid sind, wenn das Fluid in den Fluidkanal eingebracht ist (z.B. diesen durchströmt).

Der Begriff "lösbar" im Kontext einer Verbindung kann verstanden werden, dass die Verbindung zerstörungsfrei hergestellt und/oder wieder aufgehoben werden kann. Dies kann beispielsweise erreicht werden mittels Verbindungselementen (z.B. Formschlusselementen) die bei Kontakt eine formschlüssige oder kraftschlüssige Verbindung herstellen (z.B. ineinander verhaken oder gegeneinander geklemmt) oder mittels eines Riegels formschlüssig oder kraftschlüssig miteinander verbunden werden können. Das hierin exemplarisch für einen Formschluss beschriebene kann in Analogie auch für einen Kraftschluss gelten.

Als Spritzgießen (auch als Spritzguss oder Spritzgussverfahren bezeichnet) kann ein Urformverfahren verstanden werden, das beispielsweise in der Kunststoffverarbeitung eingesetzt wird. Das Spritzgießen weist auf mittels einer Spritzgießmaschine den jeweiligen Werkstoff zu verflüssigen (oder plastifizieren) und in eine Form, dem Spritzgießwerkzeug, unter Druck einzuspritzen. Als Resultat des Spritzgießens wird ein Spritzgussprodukt erhalten.

Das Temperierkörpergehäuse kann mindestens zwei (d.h. zwei oder mehr als zwei), z.B. mindestens drei (d.h. 3 oder mehr als 3), Teile (auch als Gehäusebestandteile bezeichnet) aufweisen oder daraus gebildet sein. Die mindestens drei Gehäusebestandteile können beispielsweise horizontal angeordnet und/oder miteinander (z.B. fluidleitend) verbunden sein. Beispiele für die mindestens drei Gehäusebestandteile weisen auf: eine oder mehr als eine Gehäuseendkappe; und ein oder mehr als ein Gehäusemittelteil.

Das Temperierkörpergehäuse kann eingerichtet sein, im Betrieb fluiddurchströmt (z.B. wasserdurchströmt) zu sein oder zu werden.

Zwei oder mehr als zwei Gehäusebestandteile der mindestens drei Gehäusebestandteile können optional stoffschlüssig miteinander verbunden sein, z.B. mittels Schweißens (mittels Schweißtechnik), Lötens (mittels Löttechnik) oder Klebens (mittels Klebetechnik). Beispielsweise können eine oder mehr als eine Gehäuseendkappe und der Gehäusemittelteil stoffschlüssig miteinander verbunden sein, z.B. mittels Schweißens (mittels Schweißtechnik), Lötens (mittels Löttechnik) oder Klebens (mittels Klebetechnik).

Optional können zwei oder mehr als zwei Gehäusebestandteile der der mindestens drei Gehäusebestandteile formschlüssig miteinander verbunden sein, z.B. mittels Schraubens, Nietens, Ineinandergreifens, z.B. mittels ineinander rastender Elemente (auch als Rastelemente bezeichnet), oder mittels anderer Formschlusselemente. Beispielsweise können eine oder mehr als eine Gehäuseendkappe und der Gehäusemittelteil formschlüssig miteinander verbunden sein, z.B. mittels Schraubens, Nietens, Ineinandergreifens, z.B. mittels ineinander rastender Elemente (auch als Rastelemente bezeichnet). Ein Rastelement kann beispielsweise einen Vorsprung aufweisen, der in eine Aussparung des dazu korrespondierenden Rastelements hineingreift.

Ein, zwei oder mehr als zwei Gehäusebestandteile der mindestens drei Gehäusebestandteile können jeweils monolithisch ausgebildet sein. Erfindungsgemäß ist der oder jeder Gehäusemittelteil des Temperierkörpergehäuses monolithisch ausgebildet. Zusätzlich kann eine oder mehr als eine Gehäuseendkappe des Temperierkörpergehäuses monolithisch ausgebildet sein.

Gemäß verschiedenen Ausführungsformen kann das Temperierkörpergehäuse genau zwei Gehäuseendkappen aufweisen. Dies vereinfacht die Konstruktion und/oder das Montieren des Temperierkörpergehäuses.

Das Temperierkörpergehäuse (z.B. die mindestens drei Gehäusebestandteile) kann einen Verbund aus Metall und Kunststoff aufweisen oder daraus gebildet sein.

Die mindestens drei Gehäusebestandteile können einen mittleren Gehäusebestandteil (auch als Gehäusemittelteil bezeichnet) aufweisen, der ein hoch-wärmeleitfähiges Metall aufweist oder daraus gebildet ist. Das hoch-wärmeleitfähige Metall weist auf: Kupfer, Aluminium, oder Legierungen davon. Alternativ oder zusätzlich kann der Gehäusemittelteil Stahl aufweisen oder daraus gebildet sein.

Das Metall und der Kunststoff des Temperierkörpergehäuses können derart eingerichtet sein, dass sich diese in ihrem thermischen Längenausdehnungskoeffizienten (von beiden Materialien) um weniger als ungefähr 10% voneinander unterscheiden.

Das Temperierkörpergehäuse (z.B. ein oder mehr als ein Gehäusebestandteil) kann eine Klebekante aufweisen, welche strukturiert ist. Die Klebekante kann beispielsweise eine rauhstrukturierte Oberfläche oder eine profilierte Oberfläche aufweisen. Die Klebekante kann die Oberfläche bzw. Kontaktfläche zwischen den Gehäusebestandteilen erhöhen, damit eine Klebeverbindung zwischen diesen zuverlässiger und fluiddicht ist.

Das Temperierkörpergehäuse kann (z.B. zwei oder mehr Gehäusebestandteile können) mittels Vernietung oder Verschraubung miteinander verbunden sein oder werden.

Der Gehäusemittelteil kann mittels eines Strangpressverfahren hergestellt sein oder werden.

Gemäß einem Vergleichsbeispiel kann der Gehäusemittelteil zwei Halbschalen aufweisen oder daraus gebildet sein, welche zusammengefügt einen oder mehr als einen Fluidkanal bilden, der den Gehäusemittelteil durchdringt. Die Halbschalen können beispielsweise eingerichtet sein, zusammengefügt ineinanderzugreifen und/oder eine möglichst große Oberfläche zwischen Fluid und Temperierkörper bereitzustellen.

Die große Oberfläche kann mittels Rippen (auch als Temperierrippen, z.B. Kühlrippen, bezeichnet) erzeugt sein oder werden.

Die Halbschalen des Vergleichsbeispiels können zum Abfangen der Druckkräfte mittels Bolzen, die beispielsweise verklebt oder verschraubt werden, gegeneinander gehalten werden.

Das Temperierkörpergehäuse oder zumindest der Gehäusemittelteil kann beidseitig oben und unten symmetrisch eingerichtet sein, so dass das elektrische Bauteil als zu temperierende (z.B. kühlende) Komponente sowohl auf der Oberseite als auch auf der Unterseite montiert werden kann.

Das Temperierkörpergehäuse kann zwei oder mehr Gehäusebestandteile aufweisen, die zusammengefügt einander durchdringen. Dies erhöht die Oberfläche bzw. Kontaktfläche zwischen den Gehäusebestandteilen, was es beispielsweise erleichtert, eine Klebeverbindung zuverlässig und dicht für Fluide bereitzustellen.

Der Gehäusemittelteil (auch als temperierender, z.B. kühlender, Mittelteil bezeichnet) kann wärmeleitendes Metall aufweisen oder daraus gebildet sein und/oder im Wesentlichen eine oder mehr als eine glatte Schnittkante aufweisen (z.B. an den Stirnseiten).

Der Gehäusemittelteil kann ein Profil aufweisen oder daraus gebildet sein. Beispielsweise kann der Gehäusemittelteil als Hohlkammerprofil ausgebildet sein und/oder und im Wesentlichen zur Führung eines Fluids geeignet sein.

Die Gehäuseendkappe(n) kann/können derart ausgebildet sein, dass auf der einen Seite eine Hohlkammer bereitgestellt wird, welche die Hohlräume derart ausgebildet hat, dass bei der gewünschten Durchflussgeschwindigkeit die Strömungsverteilung so eingestellt wird, dass eine im Wesentlichen gleichförmige Durchströmung gewährleistet wird.

Die Gehäuseendkappe(n) kann/können derart ausgebildet sein, dass auf der einen Seite eine Hohlkammer bereitgestellt wird, welche die Hohlräume so ausgebildet hat, dass bei der gewünschten Durchflussgeschwindigkeit die Strömungsverteilung so eingestellt wird, dass bestimmte Bereiche stärker und bestimmte Bereiche weniger stark durchströmt werden, so dass die Temperierleistung (z.B. Kühlleistung) über die Fläche so eingestellt werden kann, dass auch eine inhomogene Wärmeabgabe des zu temperierenden (z.B. kühlenden) Bauteils derart temperiert (z.B. gekühlt) werden kann, dass eine im Wesentlichen gleichmäßige Erwärmung des Fluides erfolgt und somit eine im wesentlichen gleichmäßige Erwärmung des Kühlkörpers sowie eine im Wesentlichen gleichmäßige Temperatur des zu kühlenden Bauteils.

Das maximal hohe Temperaturniveau kann erreicht bzw. optimiert werden mittels beispielsweise der Gestaltung des Temperiermoduls (z.B. durch maximal hohe Wärmeübergangsfläche) und/oder mittels beispielsweise einer hohen thermischen Effizienz (z.B. durch geschickte Materialauswahl verbleibt die Wärme, die mittels des Fluids von dem zu kühlendem Bauteil aufgenommen wird, in dem Fluid und wird nicht über z.B. Oberflächen des Temperiermoduls an die Umgebung abgegeben (z.B. konvektiv und/oder durch Wärmestrahlung)).

Das maximal hohe Temperaturniveau führt einerseits dazu, dass die Rückkühlung effizienter und auch mittels freier Kühlung (d.h. rein passive Abgabe der thermischen Energie an die Umgebung) bei höheren Außentemperaturen erfolgen kann. Das maximal hohe Temperaturniveau ermöglicht andererseits eine Abwärmenutzung, beispielsweise zur Gebäudeheizung, oder es kann die Abwärme als Triebkraft, beispielsweise einer Absorptionswärmepumpe, genutzt werden.

Der Gehäusemittelteil kann ein Profil aufweisen oder daraus gebildet sein, welches in zwei Dimensionen im Wesentlichen geschlossene Fluidkanäle aufweist.

Die Gehäuseendkappe(n) kann/können derart ausgebildet sein, dass sie derart mit den Fluidkanälen verbunden werden können, dass eine mäanderförmige Durchströmung der Fluidkanäle erzeugt wird. Diese Durchströmung hemmt einen Temperaturgradienten der zu temperierenden (z.B. kühlenden) Oberfläche. Der Temperaturgradient wird beispielsweise gehemmt, indem ein Paar Fluidkanäle einen mäanderförmigen Strömungspfad bereitstellen (anschaulich ein Fluidkanal des Fluidkanalpaares den Fluidvorlauf der andere den Fluidrücklauf darstellt). Der mäanderförmige Strömungspfad kann aber muss nicht notwendigerweise von der Gesamtanzahl der Fluidkanäle bereitgestellt werden.

Das Temperierkörpergehäuse kann eine Wärmeleitsubstanz (z.B. ein Pad, eine Paste, einen Kleber oder eine Flüssigkeit) räumlich variierender Dicke und/oder räumlich variierender Wärmeleitfähigkeit aufweisen.

Das Temperierkörpergehäuse kann eine Wärmeleitsubstanz aufweisen, welcher derart eingerichtet ist, dass sie im Wesentlichen einen Temperaturgradienten, der in dem Temperierkörpergehäuse in Durchströmungsrichtung entsteht, zumindest teilweise kompensiert, z.B. derart, dass mehrere zu temperierende (z.B. kühlende) Bauteilkomponenten im Wesentlichen das gleiche Temperaturniveau und die gleiche Temperierleistung (z.B. Kühlleistung) erfahren.

Um eine Dicke, Anordnung und/oder Wärmeleitfähigkeit der Wärmeleitsubstanz zu ermitteln, kann eine thermische Simulationen verwendet werden.

Die Gehäuseendkappe(n) kann/können verschraubt oder vernietet sein.

Der Gehäusemittelteil kann derart eingerichtet sein, dass ein direktes Einschrauben in dem Gehäusemittelteil (zum Verbinden einer Gehäuseendkappe mit diesem) erfolgen kann, z.B. ohne Nachbearbeitung und/oder mittels einer oder mehr als einer selbstschneidenden Schraube.

Der Gehäusemittelteil kann beispielsweise durch thermische Simulation derart ausgelegt sein, dass trotz Verschraubungsstrukturen eine im Wesentlichen gleichmäßige Temperierung (z.B. Kühlung) erfolgt.

Das Temperierkörpergehäuse kann eine oder mehr als eine Verbindungsstelle (zwischen zwei Gehäusebestandteilen) aufweisen, welche eingerichtet ist, wahlweise mit oder ohne Dichtung (bzw. Dichtmaterial) versehen zu werden. Beispielsweise können Turbulatoren eingebracht werden. Alternativ oder zusätzlich kann gezielt eine definierte Oberflächenstruktur/-Rauheit erreichen, dass der Wärmeübergang im Strömungskanal erhöht wird.

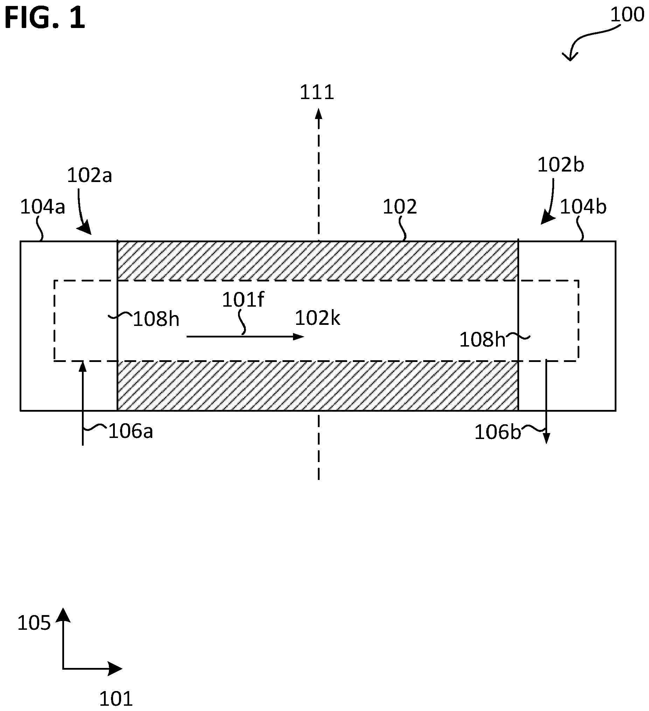

**Fig.1** veranschaulicht ein Temperierkörpergehäuse 100 gemäß verschiedenen Ausführungsformen in einer schematischen Seitenansicht oder Querschnittsansicht. Das Temperierkörpergehäuse weist auf: einen monolithischen Gehäusemittelteil 102, eine erste Gehäuseendkappe 104a und eine zweite Gehäuseendkappe 104b, welche beispielsweise aneinandergrenzen oder zumindest unmittelbar einander gegenüberliegen.

Der Gehäusemittelteil 102 ist monolithisch eingerichte (d.h. einstückig) z.B. frei von Fügungsnähten (wie beispielsweise Schweißnähten und/oder Klebenähten).

Beispielsweise kann der Gehäusemittelteil 102 ein Metall aufweisen oder daraus gebildet sein. Das Metall kann beispielsweise eines oder mehr als eines aus Folgenden Metallen aufweisen oder daraus gebildet sein (z.B. eine Legierung oder Verbindung aus zwei Metallen): Aluminium, Gold, Silber, Magnesium und/oder Kupfer.

Der Gehäusemittelteil 102 kann wärmeleitfähig eingerichtet sein, z.B. aus einem Material gebildet sein, welches wärmeleitfähig ist. Als wärmeleitfähig kann hierin verstanden werden, als eine Wärmeleitfähigkeit aufweisend von ungefähr 100 Watt pro Meter und Kelvin (W/m·K) oder mehr, zum Beispiel ungefähr 200 W/m·K oder mehr (auch als hoch-wärmeleitfähig bezeichnet), zum Beispiel ungefähr 300 W/m·K oder mehr, zum Beispiel ungefähr 400 W/m·K oder mehr. Je größer die Wärmeleitfähigkeit ist, desto effizienter kann das Temperierkörpergehäuse 100 arbeiten.

Der Gehäusemittelteil 102 ist von einem oder mehr als einem Fluidkanal 102k durchdrungen. Mit anderen Worten erstreckt sich der oder jeder Fluidkanal 102k von einer ersten Seite 102a (z.B. Stirnseite) des Gehäusemittelteils 102 zu einer zweiten Seite 102b (z.B. Stirnseite) des Gehäusemittelteils 102 durch den Gehäusemittelteil 102 hindurch (entlang Richtung 101). Der oder jeder Fluidkanal 102k kann beispielsweise einen Eingang (auch als Kanaleingang bezeichnet) an der ersten Seite 102a des Gehäusemittelteils 102 und einen Ausgang (auch als Kanalausgang bezeichnet) an der zweiten Seite 102b des Gehäusemittelteils 102 aufweisen.

Der Gehäusemittelteil 102 kann beispielsweise im Wesentlichen quaderförmig sein.

Der Gehäusemittelteil 102 ist zwischen der ersten Gehäuseendkappe 104a und der zweiten Gehäuseendkappe 104b angeordnet. Die erste Gehäuseendkappe 104a kann auf der ersten Seite 102a (z.B. Stirnseite) des Gehäusemittelteils 102 angeordnet und/oder mit dieser verbunden sein. Die zweite Gehäuseendkappe 104b kann auf der zweiten Seite 102b (z.B. Stirnseite) des Gehäusemittelteils 102 angeordnet und/oder mit dieser verbunden sein.

Die erste Gehäuseendkappe 104a weist einen ersten Fluidanschluss 106a auf. Die zweite Gehäuseendkappe 104b weist einen zweiten Fluidanschluss 106b auf. Der erste Fluidanschluss 106a und der zweite Fluidanschluss 106b sind mittels des einen oder mehr als einen Fluidkanals 102k fluidleitend miteinander verbunden.

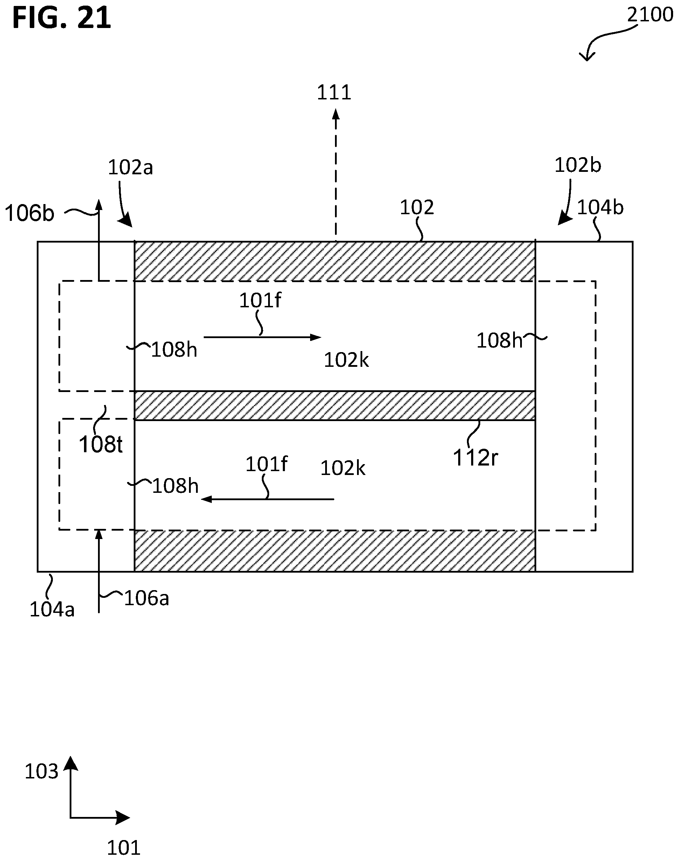

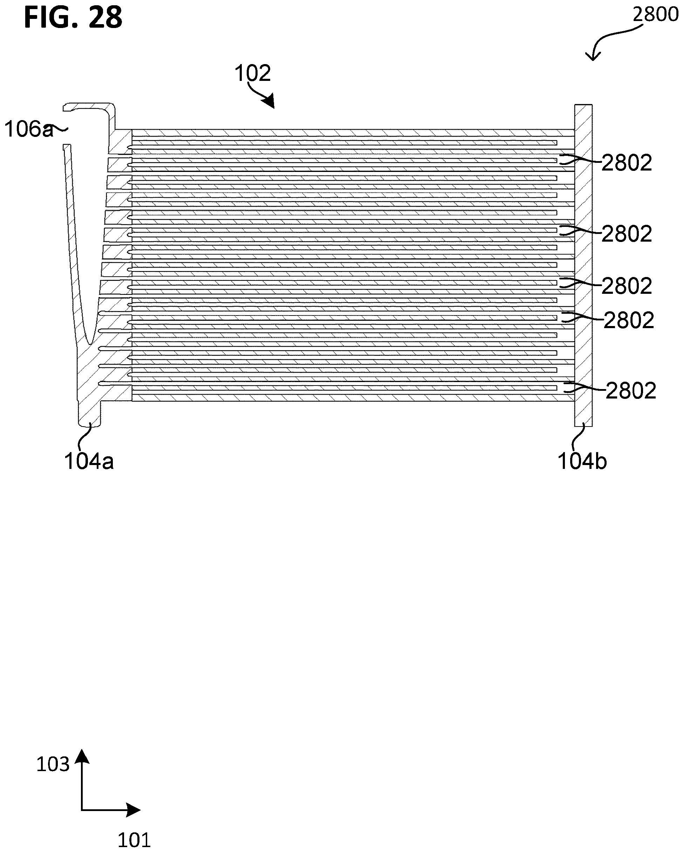

Beispielsweise kann der jeweilige Fluidanschluss 106a, 106b an den einen oder mehr als einen Fluidkanal 102k angrenzen. Der jeweilige Fluidanschluss einer Gehäuseendkappe kann beispielsweise an dieser oben, unten oder stirnseitig angeordnet sein. Bei Ausführungsformen mit einer internen Umlenkung des Strömungspfads innerhalb des Temperierkörpers (z.B. mittels eines Paars Fluidkanäle, die paarweise einen mäanderförmig Strömungspfad bereitstellen) kann eine Gehäuseendkappe 104a beide Fluidanschlüsse aufweisen (vgl. beispielsweise Fig.21 und Fig.28).

Beispielsweise kann die jeweilige Gehäuseendkappe 104a, 104b einen Hohlraum 108h aufweisen, welcher den Fluidanschluss 106a, 106b der Gehäuseendkappe 104a, 104b mit dem einen oder mehr als einen Fluidkanal 102k fluidleitend verbindet. Letzteres verbessert die Fluidverteilung.

Der oder jeder Fluidanschluss 106a, 106b kann beispielsweise hervorstehen, so dass beispielsweise ein Schlauch aufgesteckt werden kann. Der Schlauch kann beispielsweise an dem jeweiligen Fluidanschluss 106a, 106b befestigt und/oder gesichert werden, z.B. mittels einer Klammer, einer Überwurfmutter oder einer Kickverbindung.

Der oder jeder Fluidanschluss 106a, 106b kann beispielsweise einen hervorstehenden Rohrstumpf aufweisen oder daraus gebildet sein. Der oder jeder Fluidanschluss kann beispielsweise eine Dichtung aufweisen oder daraus gebildet sein, z.B. eine Ringdichtung. Der oder jeder Fluidanschluss kann beispielsweise ein Gewinde aufweisen. Der oder jeder Fluidanschluss kann beispielsweise einen Klickverschluss (d.h. einen selbst einrastenden Verschluss) aufweisen.

Im Betrieb kann dem Temperierkörpergehäuse 100 ein Temperierfluid (z.B. Kühlfluid) zugeführt werden mittels des ersten Fluidanschlusses 106a. Das Temperierfluid durchströmt den Gehäusemittelteil 102 und kann dem Temperierkörpergehäuse mittels des zweiten Fluidanschlusses 106b wieder entzogen werden. Dazu strömt das Temperierfluid aus der ersten Gehäuseendkappe 104a durch den einen oder mehr als einen Fluidkanal 102k hindurch in die zweiten Gehäuseendkappe 104b hinein.

Dementsprechend kann das Temperierkörpergehäuse 100 einen Fluidführungspfad von dem ersten Fluidanschluss 106a zu dem zweiten Fluidanschluss 106b bereitstellen. Der Fluidführungspfad kann beispielsweise mehrere nebeneinander verlaufende Zweige aufweisen, welche parallel zueinander verschaltet sind (z.B. aufgefächert sein). Der Fluidführungspfad kann beispielsweise mäanderförmig verlaufen.

Das Temperierfluid kann beispielsweise ein Temperiergas und/oder eine Temperierflüssigkeit aufweisen oder daraus gebildet sein. Beispielsweise kann das Temperierfluid Wasser aufweisen oder daraus gebildet sein. Alternativ oder zusätzlich kann das Temperierfluid ein Öl aufweisen oder daraus gebildet sein, z.B. ein synthetisches und/oder mineralisches Öl. Alternativ oder zusätzlich kann das Temperierfluid die Schmelze eines Salzes aufweisen oder daraus gebildet sein. Im Allgemein kann verstanden werden, dass ein beliebiges geeignetes fluides Medium (auch als Fluid bezeichnet) als Temperierfluid verwendet werden kann.

Im Betrieb des Temperierkörpergehäuses 100 kann eine Strömungsrichtung 101f des Temperierfluids vom Kanaleingang zum Kanalausgang gerichtet sein. Richtung 103 und/oder Richtung 105 können quer zur Strömungsrichtung 101f sein. Richtung 101 kann in oder entgegen der Strömungsrichtung 101f sein.

Weist der Gehäusemittelteil 102 mehr als einen Fluidkanal 102k auf, kann die Anzahl der Fluidkanäle 102k des Gehäusemittelteils 102 zumindest 2 (d.h. 2 oder mehr) sein, z.B. zumindest 3, z.B. zumindest 5, z.B. zumindest 10, z.B. zumindest 15, z.B. zumindest 20. Je größer die Anzahl der Fluidkanäle 102k des Gehäusemittelteils 102 ist, desto größer kann die Temperierleistung sein. Alternativ oder zusätzlich kann eine Strömungshomogenisierung (Vergleichmäßigung) mittels der Gestaltung der Gehäuseendkappen erreicht werden. Beispielhafte Maßnahmen zur Strömungshomogenisierung weisen auf: das Einbringen einer oder mehrerer Prallplatten und/oder das Einbringen einer oder mehrerer Fluidleitbleche in die Gehäuseendkappe(n).

Hierin wird zur Vereinfachung des Verständnisses unter anderem Bezug genommen auf Eigenschaften eines Fluidkanals 102k des Gehäusemittelteils 102. Es kann verstanden werden, dass das für den einen Fluidkanal 102k Beschriebene optional für jeden mehrerer Fluidkanäle 102k des Gehäusemittelteils 102 gelten kann, beispielsweise für jeden Fluidkanal 102k des Gehäusemittelteils 102.

Einander unmittelbar benachbarte Fluidkanäle 102k des Gehäusemittelteils 102 können voneinander separiert sein (auch als fluidsepariert bezeichnet), z.B. mittels einer Trennwand, wie später noch genauer beschrieben wird.

Optional können der Gehäusemittelteil 102 und die Gehäuseendkappen 104a sich voneinander unterscheiden in ihrer chemischen Zusammensetzung und/oder Wärmeleitfähigkeit. Alternativ oder zusätzlich können der Gehäusemittelteil 102 und die Gehäuseendkappen 104a sich voneinander unterscheiden in der Art ihrer Herstellung. Dies vereinfacht die Herstellung und wird nachfolgend genauer erläutert.

Beispielsweise kann die erste Gehäuseendkappe 104a und/oder die zweite Gehäuseendkappe 104b einen Kunststoff aufweisen oder aus dem Kunststoff gebildet sein. Der Kunststoff kann beispielsweise ein thermoplastischer Kunststoff oder Teil eines Verbundmaterials sein. Dies erleichtert es, die jeweilige Gehäuseendkappe 104a, 104b mittels eines Gussverfahrens herzustellen, was wiederum besonders kostengünstig ist. Alternativ kann selbstverständlich auch ein anderer Kunststoff oder Verbundmaterial verwendet werden, beispielsweise, um die Haltbarkeit zu steigern und/oder den thermischen Ausdehnungskoeffizienten an den Gehäusemittelteil 102 anzupassen.

Optional kann der Gehäusemittelteil 102 ein Strangpressprodukt aufweisen oder aus einem Strangpressprodukt gebildet sein. Das Strangpressprodukt kann aus einem Pressling (z.B. aus Metall) gebildet sein.

Das Strangpressen ist ein kontinuierlich erfolgendes Umformverfahren zum Herstellen eines Strangs vordefinierter Form aus dem Pressling. Der Pressling kann beispielsweise ein Metall aufweisen oder daraus gebildet sein, wie beispielsweise eine Eisenlegierung oder eine Nichteisenlegierung. Beim Strangpressen wird der erhitzte aber noch feste Pressling (z.B. das Metall) durch eine Matrize gedrückt und mittels dieser verformt, wobei das Resultat dessen als sogenannter Strang wieder austritt. Dabei wird der Pressling durch einen Rezipienten - ein sehr dickwandiges Rohr - umschlossen. Danach wird der Strang in mehrere Segmente (auch als Strangsegment bezeichnet) geteilt. Der Gehäusemittelteil 102 kann auf Grundlage eines Strangsegments (auch als Strangpressprodukt bezeichnet) gebildet sein, z.B. mit oder ohne Nachbearbeitung.

Das Strangpressen ist nicht zu verwechseln mit dem Strangguss. Der Strangguss gehört zu den Gießverfahren, während das Strangpressen zu den Umformverfahren gehört. Das kontinuierliche Herstellungsverfahren, z.B. das Strangpressen, erreicht eine besonders kostengünstige Herstellung des Gehäusemittelteils 102 mit ausreichend hoher Präzision.

Als Folge des kontinuierlichen Herstellungsverfahrens kann das Strangpressprodukt (z.B. der gesamte Gehäusemittelteil 102) spiegelsymmetrisch sein, beispielsweise bezüglich einer Ebene 111 (dann auch als Spiegelebene bezeichnet). Alternativ oder zusätzlich kann Strangpressprodukt (z.B. der gesamte Gehäusemittelteil 102) zumindest abschnittsweise translationssymmetrisch sein, z.B. entlang Richtung 101, die beispielsweise quer zu der Ebene 111 ist.

Die Ebene 111 kann beispielsweise quer zur Richtung 101 sein und von den Richtungen 103, 105 aufgespannt werden.

Beispielsweise kann der Gehäusemittelteil 102 zylinderförmig sein (im Sinne eines allgemeinen Zylinders, z.B. mit mehreckiger Grundfläche). Der Zylinder entsteht, wenn die Kontur der ersten Seite 102a des Gehäusemittelteils 102 entlang Richtung 101 verschoben wird um die Länge des Gehäusemittelteils 102, wo es dann die zweite Seite 102b bildet. Mit anderen Worten können die erste Seite 102a und die zweite Seite 102b in ihrer Kontur im Wesentlichen übereinstimmen.

Optional kann der Gehäusemittelteil 102 im Wesentlichen denselben thermischen Ausdehnungskoeffizienten (hierin auch vereinfacht als Ausdehnungskoeffizient bezeichnet) aufweisen wie die erste Gehäuseendkappe 104a und/oder wie die zweite Gehäuseendkappe 104b. Mit anderen Worten können deren Ausdehnungskoeffizienten weniger als ungefähr 25% relativ voneinander abweichen. Als relative Abweichung kann hierin beispielsweise das Verhältnis der Abweichung zum arithmetischen Mittel verstanden werden. In Formeln ausgedrückt kann der Gehäusemittelteil 102 einen ersten Ausdehnungskoeffizienten A1 aufweisen und die erste Gehäuseendkappe 104a bzw. die zweite Gehäuseendkappe 104b kann einen zweiten Ausdehnungskoeffizienten A2 aufweisen. Das Verhältnis der Abweichung |A1-A2| zum arithmetischen Mittel (A1+A2)/2 ist dann |A1-A2|/(A1/2+A2/2) = a, wobei die relative Abweichung a ≤ 0,25 (d.h. 25%) ist. Die relative Abweichung a kann aber auch kleiner sein als ungefähr 25%, z.B. ungefähr 10% oder weniger, z.B. ungefähr 5% oder weniger, z.B. ungefähr 1% oder weniger.

Dies erreicht, dass das Temperierkörpergehäuse 100 strukturell besonders invariant gegenüber Temperaturschwankungen ist. Beispielsweise wird dadurch gehemmt, dass Undichtheiten entstehen, beispielsweise, je geringer die relative Abweichung ist.

Dass die Ausdehnungskoeffizienten weniger als 25% relativ voneinander abweichen, kann erreicht werden, indem die Materialien des Gehäusemittelteil und/oder der Gehäuseendkappe(n) derart ausgewählt werden, dass der Unterschied im Ausdehnungskoeffizienten minimiert wird.

Dies kann beispielsweise durch die Verwendung von Kupfer als thermisch hoch-wärmeleitfähiges und Glasfasergefüllten Kunststoff erreicht werden. Als Beispiel ist ein spezielles Polyamide-Imide (PAI) mit einem Glasfaseranteil von 30 % zu nennen. Die relative Abweichung der thermischen Ausdehnungskoeffizienten beträgt zwischen diesem Spezialkunstoff und Reinkupfer nach der oben beschriebenen Berechnungsmethode ungefähr 3 %.

Optional können der Kanaleingang und der Kanalausgang des Fluidkanals 102k in ihrer Querschnittsfläche weniger als ungefähr 25% relativ voneinander abweichen, z.B. ungefähr 10% oder weniger, z.B. ungefähr 5% oder weniger, z.B. ungefähr 1% oder weniger.

Beeinträchtigende Effekte aufgrund eines Unterschieds im thermischen Ausdehnungskoeffizienten können nicht nur mittels einer eindimensionalen Anpassung der Querschnittsfläche kompensiert werden, da die Auswirkung des Unterschieds im thermischen Ausdehnungskoeffizienten dreidimensionaler Natur ist.

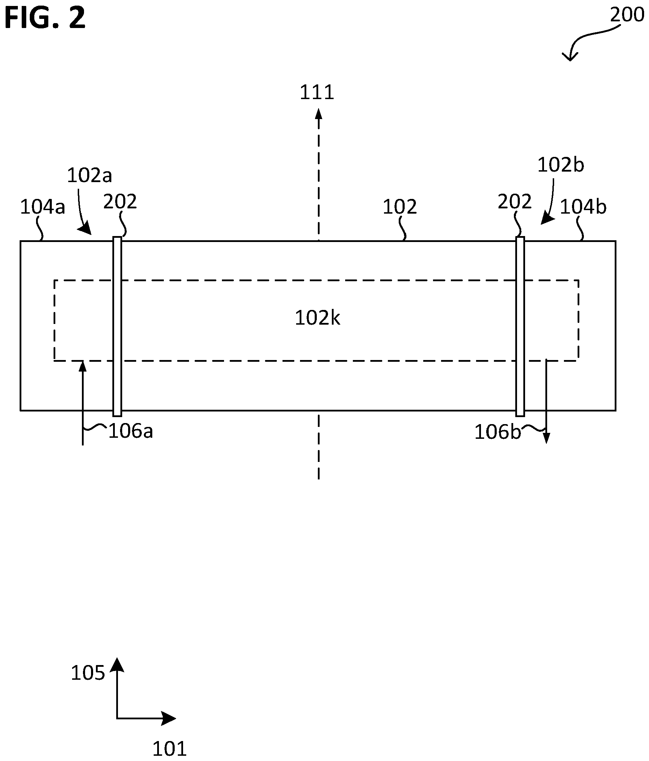

**Fig.2** veranschaulicht ein Temperierkörpergehäuse 100 gemäß verschiedenen Ausführungsformen 200 in einer schematischen Seitenansicht oder Querschnittsansicht. Das Temperierkörpergehäuse weist ferner eine erste Dichtung 202 auf mittels welcher der Gehäusemittelteil 102 mit der ersten Gehäuseendkappe 104a fluiddicht verbunden ist. Alternativ oder zusätzlich weist das Temperierkörpergehäuse 100 eine zweite Dichtung 202 auf mittels welcher der Gehäusemittelteil 102 mit der zweiten Gehäuseendkappe 104b fluiddicht verbunden ist.

Die Dichtung erleichtert es, das Innere des Temperierkörpergehäuses 100 gegenüber der Außenwelt abzudichten. Beispielsweise ermöglicht es die Dichtung, Fertigungstoleranzen auszugleichen.

Optional kann der Gehäusemittelteil 102 eine umlaufende erste Nut zum Aufnehmen der ersten Dichtung 202 aufweisen. Alternativ oder zusätzlich kann der Gehäusemittelteil 102 eine umlaufende zweite Nut zum Aufnehmen der zweiten Dichtung 202 aufweisen. Ist das Temperierkörpergehäuse 100 zusammengefügt, können die Dichtungen 202 jeweils in der entsprechenden Nut des Gehäusemittelteils 102 aufgenommen sein.

Optional kann die erste Gehäuseendkappe 104a eine umlaufende erste Nut zum Aufnehmen der ersten Dichtung 202 aufweisen. Alternativ oder zusätzlich kann die zweite Gehäuseendkappe 104b eine umlaufende zweite Nut zum Aufnehmen der zweiten Dichtung 202 aufweisen. Ist das Temperierkörpergehäuse 100 zusammengefügt, können die Dichtungen 202 jeweils in der entsprechenden Nut der Gehäuseendkappe 104a, 104b aufgenommen sein.

Die oder jede Dichtung 202 kann beispielsweise eine Ringdichtung aufweisen oder daraus gebildet sein. Die oder jede Dichtung 202 kann beispielsweise ein Elastomer aufweisen oder daraus gebildet sein.

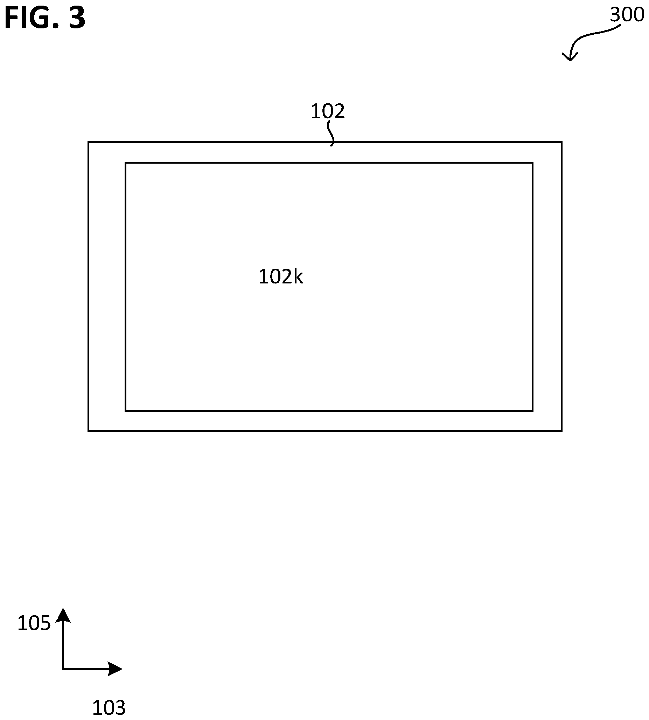

**Fig.3** veranschaulicht ein Temperierkörpergehäuse 100 gemäß verschiedenen Ausführungsformen 300 in einer schematischen Seitenansicht (z.B. auf dessen Stirnseite) oder Querschnittsansicht (z.B. entlang Ebene 111 geschnitten). Der Gehäusemittelteil 102 kann als Gehäusezarge (z.B. in Form eines Rahmens) des Temperierkörpergehäuses 100 ausgebildet sein. Als Zarge kann das seitliche einfassende Teil des Temperierkörpergehäuses 100 verstanden werden.

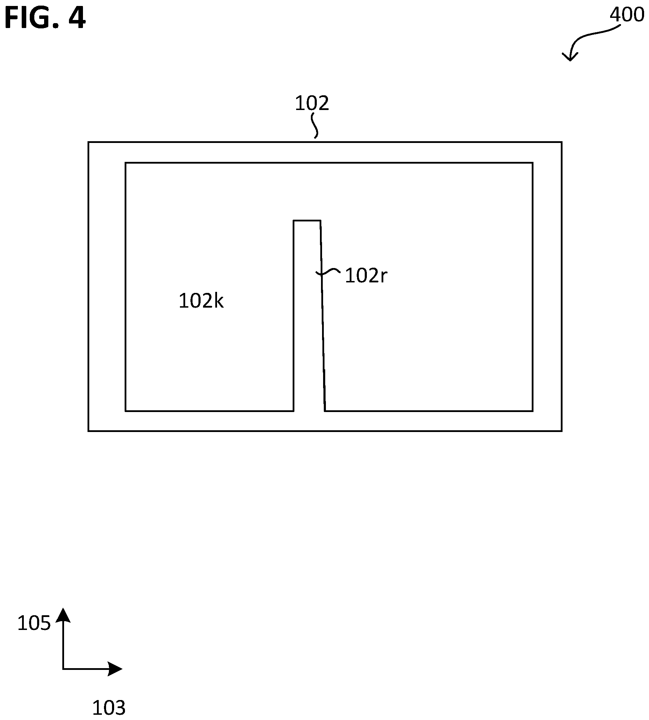

**Fig.4** veranschaulicht ein Temperierkörpergehäuse 100 gemäß verschiedenen Ausführungsformen 400 in einer schematischen Seitenansicht (z.B. auf dessen Stirnseite) oder Querschnittsansicht (z.B. entlang Ebene 111 geschnitten). Der Gehäusemittelteil 102 kann eine oder mehr als eine erste Temperierrippe 102r (auch als Temperierrippe ersten Typs bezeichnet) aufweisen, welche in den Fluidkanal 102k hinein erstreckt ist. Die Temperierrippe (z.B. Kühlrippe) ersten Typs kann beispielsweise ein freies Ende aufweisen, d.h. frei auskragen.

Mit anderen Worten kann der Fluidkanal 102k zwei nebeneinander verlaufende Kanalabschnitte aufweisen, zwischen denen eine erste Temperierrippe 102r (z.B. Kühlrippe 102r) angeordnet ist. Die Temperierrippe erhöht die wärmeübertragende Oberfläche und begünstigt damit den Wärmeübergang.

Je höher (Ausdehnung entlang Richtung 105) die erste Temperierrippe 102r ist, desto stärker können die Kanalabschnitte voneinander fluidsepariert werden. Sind die zwei Kanalabschnitte derart stark voneinander fluidsepariert, dass diese kaum noch (d.h. im Wesentlichen keine) das Temperierfluid miteinander austauschen können, können die zwei Kanalabschnitte funktionell als eigenständige Fluidkanäle betrachtet werden. Dies ist beispielsweise der Fall, wenn der Kanaleingang und/oder der Kanalausgang im Wesentlichen die einzigen Öffnungen des Fluidkanals ist.

Je mehr erste Temperierrippen 102r der Gehäusemittelteil 102 pro Fluidkanal 102k aufweist, desto größer kann die Temperierleistung sein. Beispielsweise kann die Anzahl der ersten Temperierrippen 102r pro Fluidkanal 102k zumindest 2 (d.h. 2 oder mehr) sein, z.B. zumindest 3, z.B. zumindest 5, z.B. zumindest 10, z.B. zumindest 15, z.B. zumindest 20.

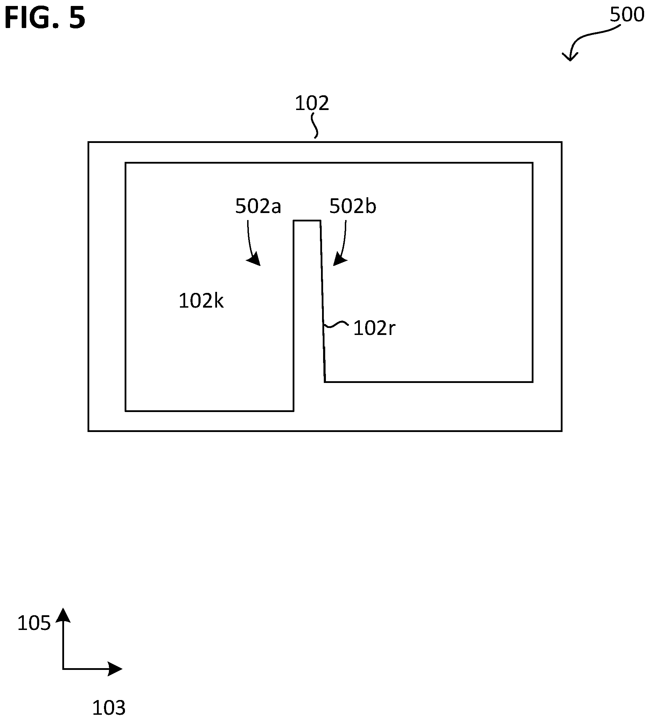

**Fig.5** veranschaulicht ein Temperierkörpergehäuse 100 gemäß verschiedenen Ausführungsformen 500 in einer schematischen Seitenansicht (z.B. auf dessen Stirnseite) oder Querschnittsansicht (z.B. entlang Ebene 111 geschnitten). Die oder jede erste Temperierrippe 102r kann eine asymmetrische Kontur (z.B. im Schnitt nach Ebene 111) aufweisen. Anschaulich kann die erste Temperierrippe 102r beispielsweise abgeschrägt sein oder beispielsweise links und rechts unterschiedlich lang sein.

Beispielsweise können die Kanalabschnitte des Fluidkanals 102k, zwischen denen die erste Temperierrippe 102r angeordnet ist, wie dargestellt, sich in ihrer Höhe (Ausdehnung entlang Richtung 105) voneinander unterscheiden. Dies erreicht, dass die erste Temperierrippe 102r einander gegenüberliegende Seitenflächen 502a, 502b aufweist, welche an den Fluidkanal angrenzen und sich voneinander unterscheiden, z.B. in ihrer Oberfläche und/oder Ausdehnung (z.B. entlang der Erstreckungsrichtung der Temperierrippe).

Diese Asymmetrie (zum Beispiel der Seitenflächen 502a, 502b) erreicht, dass die Temperierleistung räumlich angepasst werden kann. Beispielsweise kann die Temperierleistung derart angepasst sein, dass einem Gradienten (d.h. ein kontinuierliches Gefälle) in der Temperatur des Temperierfluids entgegengewirkt wird.

Der Gradient in der Temperatur des Temperierfluids kann beispielsweise dadurch entstehen, dass sich das Temperierfluid beim Hindurchströmen durch das Temperierkörpergehäuse 100 nach und nach erwärmt. Dadurch kann ein Gradient im Temperaturunterschied zwischen dem Temperierfluid und dem Temperierkörpergehäuse 100 bzw. ein Gradient in der Wärmeaufnahmeleistung des Temperierfluids entstehen.

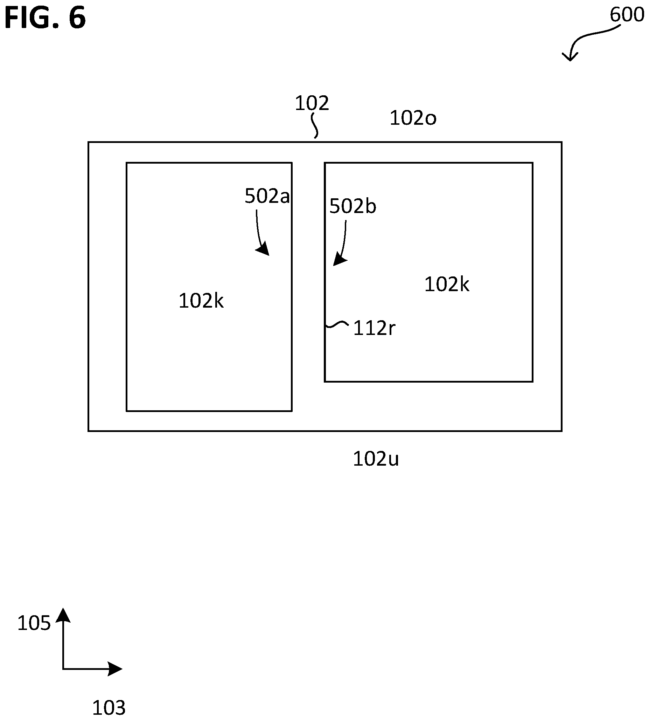

**Fig.6** veranschaulicht ein Temperierkörpergehäuse 100 gemäß verschiedenen Ausführungsformen 600 in einer schematischen Seitenansicht (z.B. auf dessen Stirnseite) oder Querschnittsansicht (z.B. entlang Ebene 111 geschnitten). Der Gehäusemittelteil 102 kann zwei einander unmittelbar benachbarte Fluidkanäle 102k aufweisen und ferner eine zweite Temperierrippe 112r (auch als Temperierrippe zweiten Typs oder fluidseparierende Temperierrippe bezeichnet), welche die zwei Fluidkanäle 102k voneinander separiert. Mit anderen Worten kann die zweite Temperierrippe 112r (z.B. Kühlrippe 112r) als Trennwand ausgebildet sein, welche die zwei Fluidkanäle 102k voneinander fluidsepariert.

Die als Trennwand ausgebildete zweite Temperierrippe 112r kann sich von einer Oberseite 102o des Gehäusemittelteils 102 bis zu einer Unterseite 102u des Gehäusemittelteils 102 erstrecken. Mit anderen Worten kann die Temperierrippe 112r zweiten Typs zwei einander gegenüberliegende Seiten 102o, 102u des Gehäusemittelteils 102 miteinander verbinden.

Die zwei Fluidkanäle 102k können beispielsweise keine Fluidverbindung untereinander aufweisen, die zwischen ihrem Kanaleingang und ihrem Kanalausgang angeordnet ist.

Optional kann der Gehäusemittelteil 102 mehr als zwei Fluidkanäle 102k aufweisen (nicht dargestellt), von denen einander unmittelbar benachbarte Fluidkanäle 102k von einer der zweiten Temperierrippen 112r voneinander separiert sind. Optional kann der Gehäusemittelteil 102 pro Fluidkanal 102k oder mehr als eine erste Temperierrippe 102r (nicht dargestellt) aufweisen, welche in den Fluidkanal 102k hinein erstreckt ist.

Optional kann die oder jede zweite Temperierrippe 112r eine asymmetrische Kontur (z.B. im Schnitt nach Ebene 111) aufweisen. Das oben für die erste Temperierrippe 102r hinsichtlich der Asymmetrie Beschriebene kann beispielsweise in Analogie für die zweite Temperierrippe 112r zutreffen.

Erfindungsgemäß besitzt zumindest eine erste Temperierrippe 102r oder eine zweite Temperierrippe 112r eine asymmetrische Kontur, oder eine erste und eine zweite Temperierrippe besitzen beide eine asymmetrische Kontur.

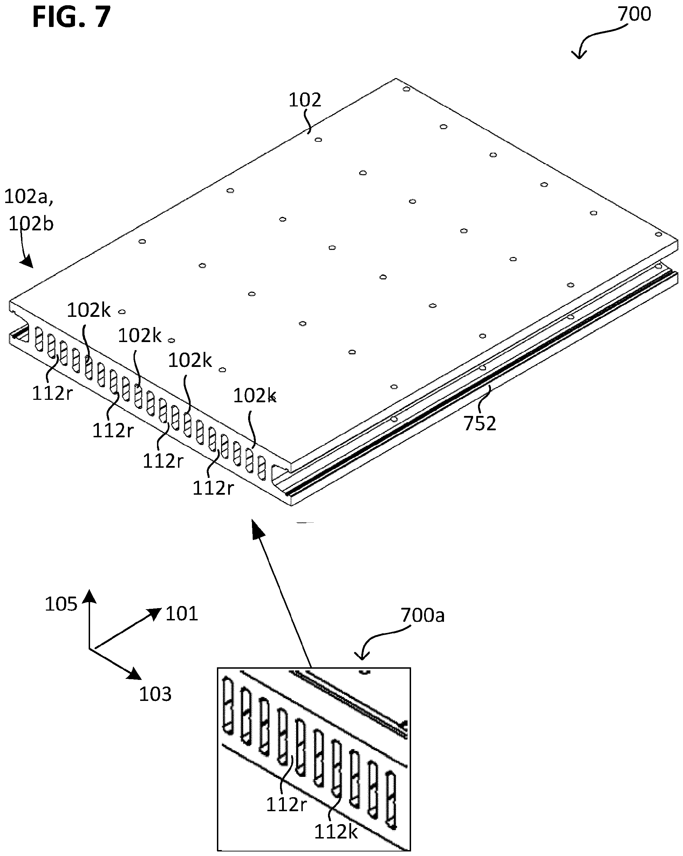

**Fig.7** veranschaulicht ein Temperierkörpergehäuse 100 gemäß verschiedenen Ausführungsformen 700 in einer schematischen Perspektivansicht und Detailansicht 700a, z.B. auf die erste Seite 102a bzw. zweite Seite 102b des Gehäusemittelteils 102.

Gemäß verschiedenen Ausführungsformen kann der Gehäusemittelteil 102 aus einem einteiligen Strangpressprofil bestehen. Die Durchströmung erfolgt von vorne nach hinten.

Wie dargestellt, kann der Gehäusemittelteil 102 mehrere Temperierkanäle 102k (z.B. Kühlkanäle 102k) aufweisen, welche in einer Reihe nebeneinander angeordnet sind. Wie dargestellt, kann der Gehäusemittelteil 102 zumindest 10 oder mehr Temperierkanäle 102k aufweisen, z.B. 20 oder mehr Temperierkanäle 102k aufweisen.

Optional kann der Gehäusemittelteil 102 seitlich eine Befestigungsstruktur 752 aufweisen. Mittels der Befestigungsstruktur 752 kann der Gehäusemittelteil 102 und damit das Temperierkörpergehäuse 100 an einer zu temperierenden (z.B. kühlenden) Elektronik befestigt werden.

Beispielsweise kann der Gehäusemittelteil 102 eine oder mehr als eine seitlich hervorstehende Lippe als Befestigungsstruktur 752 aufweisen. Die Lippe kann beispielsweise eine oder mehr als eine Durchgangsöffnung aufweisen. Die Lippe kann beispielsweise profiliert sein.

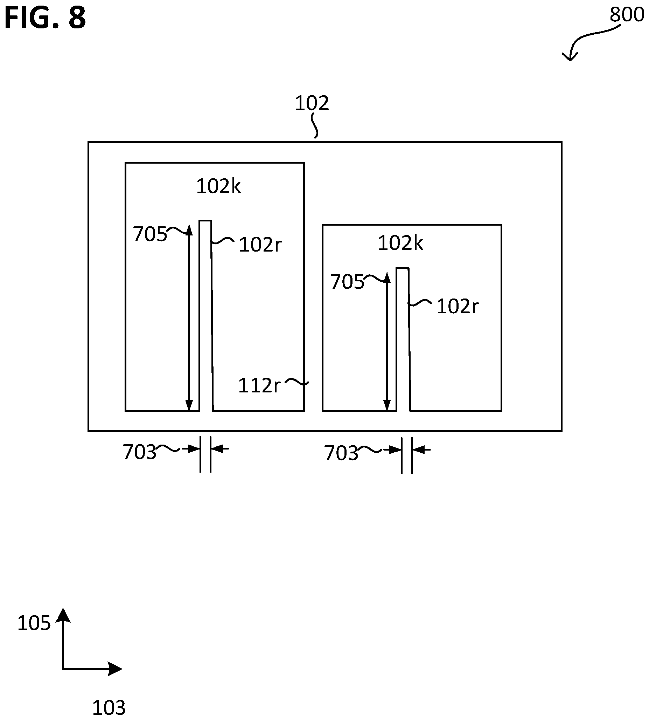

**Fig.8** veranschaulicht ein Temperierkörpergehäuse 100 gemäß verschiedenen Ausführungsformen 800 in einer schematischen Seitenansicht (z.B. auf dessen Stirnseite) oder Querschnittsansicht (z.B. entlang Ebene 111 geschnitten).

Der Gehäusemittelteil 102 kann beispielsweise mehrere Temperierrippen (z.B. ersten Typs und/oder zweiten Typs) aufweisen, welche sich in ihrer Ausdehnung 705 entlang Richtung 105 (auch als Höhe bezeichnet) voneinander unterscheiden. Alternativ oder zusätzlich kann der Gehäusemittelteil 102 mehrere Temperierrippen (z.B. ersten Typs und/oder zweiten Typs) aufweisen, welche sich in ihrer Ausdehnung 703 (auch als Dicke bezeichnet) entlang Richtung 103 voneinander unterscheiden. Richtung 103 und/oder Richtung 105 können quer zur Strömungsrichtung 101f sein.

Der Gehäusemittelteil 102 kann beispielsweise mehrere Temperierkanäle 102k aufweisen, welche sich in ihrer Ausdehnung 705 (auch als Höhe bezeichnet) entlang Richtung 105 voneinander unterscheiden. Alternativ oder zusätzlich kann der Gehäusemittelteil 102 mehrere Temperierkanäle 102k aufweisen, welche sich in ihrer Ausdehnung 703 (auch als Dicke bezeichnet) entlang Richtung 103 voneinander unterscheiden.

Der Gehäusemittelteil 102 kann beispielsweise mehrere Temperierkanäle 102k aufweisen, welche einander zugewandte Seiten aufweisen, wobei die einander zugewandten Seiten sich in ihrer Querschnittsfläche voneinander unterscheiden.

Der Gehäusemittelteil 102 kann beispielsweise mehrere Temperierkanäle 102k aufweisen, welche sich bezüglich Ebene 111 in ihrer Querschnittsfläche voneinander unterscheiden.

Die Parameter der Ausdehnung bzw. Querschnittsfläche können verwendet werden, um die die räumliche Verteilung der Temperierleistung anzupassen. Beispielsweise können die Unterschiede in der Ausdehnung bzw. Querschnittsfläche einen Unterschied in der lokalen Temperierleistung bewirken. Der Unterschied in der lokalen Temperierleistung kann beispielsweise derart eingerichtet sein, dass einem Gradienten in der Temperatur des Temperierfluid entgegengewirkt wird.

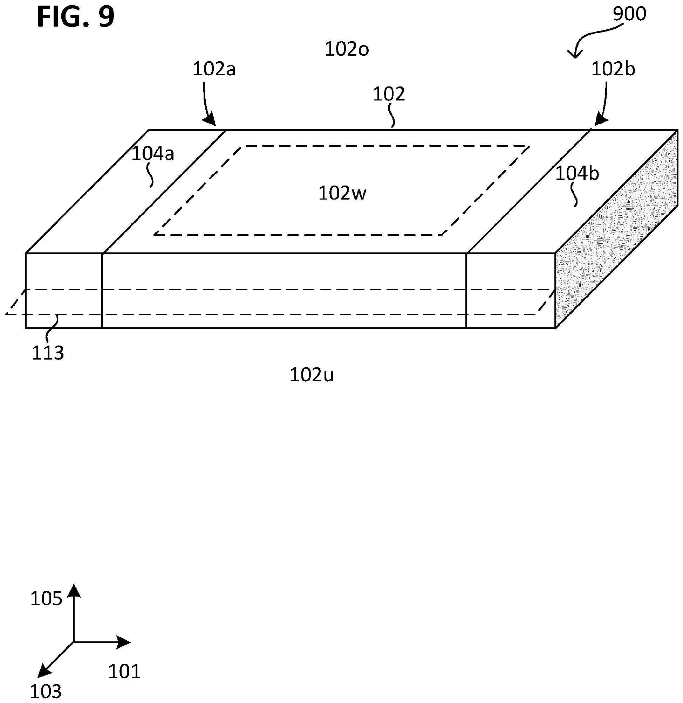

**Fig.9** veranschaulicht ein Temperierkörpergehäuse 100 gemäß verschiedenen Ausführungsformen 900 in einer schematischen Perspektivansicht. Der Gehäusemittelteil 102 kann eine oder mehr als eine Wärmeleistungsaufnahmefläche 102w aufweisen. Die oder jede Wärmeleistungsaufnahmefläche 102w kann beispielsweise zwischen der ersten Gehäuseendkappe 104a und der zweiten Gehäuseendkappe 104b angeordnet sein.

Die Wärmeleistungsaufnahmefläche 102w kann beispielsweise eben (d.h. planar) sein und optional poliert und/oder planarisiert sein.

Hierin wird unter anderem auf eine Wärmeleistungsaufnahmefläche 102w Bezug genommen. Das Temperierkörpergehäuse 100 kann allerdings auch mehr als eine Wärmeleistungsaufnahmefläche 102w aufweisen, z.B. mehrere räumlich voneinander separierte Wärmeleistungsaufnahmeflächen 102w. Das für die Wärmeleistungsaufnahmefläche 102w Beschriebene kann in Analogie für mehrere Wärmeleistungsaufnahmeflächen 102w gelten.

Optional kann der Gehäusemittelteil 102 zumindest zwei Wärmeleistungsaufnahmeflächen 102w aufweisen, zwischen denen der eine oder mehr als eine Temperierkanal 102k angeordnet ist. Beispielsweise kann der Gehäusemittelteil 102 eine oder mehr als eine erste Wärmeleistungsaufnahmefläche 102w auf einer dritten Seite 103o (anschaulich Oberseite 102o) aufweisen. Alternativ oder zusätzlich kann der Gehäusemittelteil 102 eine oder mehr als eine zweite Wärmeleistungsaufnahmefläche (in der Ansicht verdeckt) auf einer vierten Seite 102u (anschaulich Unterseite 102u) aufweisen. Dies erweitert die Einsatzmöglichkeiten des Temperierkörpergehäuses 100, da die zu temperierende (z.B. kühlende) Elektronik wahlweise auf die Unterseite 102u und/oder die Oberseite 102o montiert werden kann.

Optional kann das Temperierkörpergehäuse 100 bezüglich einer Ebene 113 (von Richtung 101 und 103 aufgespannt) spiegelsymmetrisch eingerichtet sein, so dass beidseitig eine Wärmeleistungsaufnahmefläche 102w bereitgestellt wird.

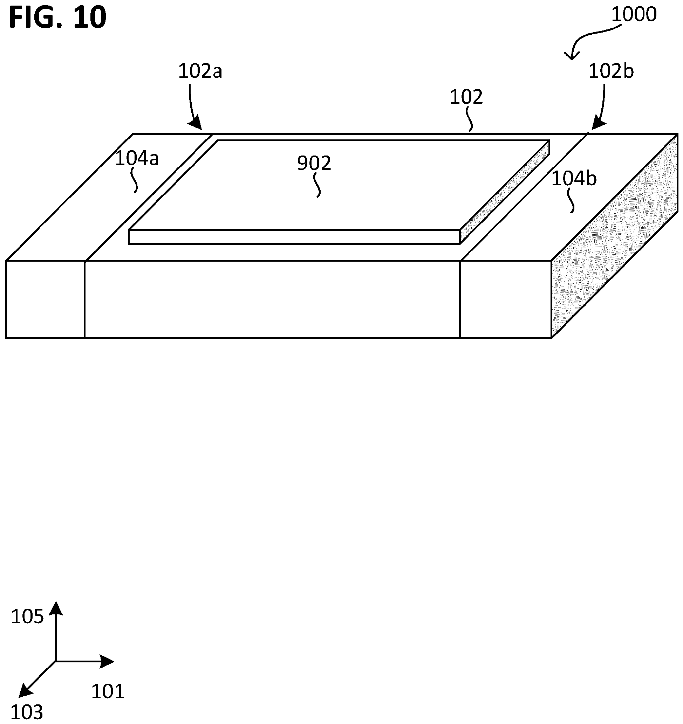

**Fig.10** veranschaulicht ein Temperierkörpergehäuse 100 gemäß verschiedenen Ausführungsformen 1000 in einer schematischen Perspektivansicht. Das Temperierkörpergehäuse kann ein Wärmeleitmaterial 902 (z.B. eine Schicht aus dem Wärmeleitmaterial) aufweisen, welches auf der Wärmeleistungsaufnahmefläche 102w angeordnet ist, z.B. in körperlichem Kontakt mit dieser.

Im Allgemeinen können verschiedene Materialien als Wärmeleitmaterial verwendet werden. Beispielsweise kann das Wärmeleitmaterial als sogenannte Wärmeleitmatte (auch als Wärmeleitpad bezeichnet) bereitgestellt sein, welche vorgefertigt ist und auf die Wärmeleistungsaufnahmefläche 102w aufgelegt wird. Alternativ oder zusätzlich kann das Wärmeleitmaterial als sogenannte Wärmeleitpaste bereitgestellt sein (d.h. das Wärmeleitmaterial kann eine viskose Paste sein), mit welcher die Wärmeleistungsaufnahmefläche 102w beschichtet wird. Das Wärmeleitmaterial kann aber auch viskoser als eine Wärmeleitpaste sein. Optional kann das Wärmeleitmaterial auch einen Kleber aufweisen oder daraus gebildet sein.

Die Wärmeleitmatte kann beispielsweise einen Kunststoff (z.B. eine Kunststofffolie) aufweisen oder daraus gebildet sein. Alternativ oder zusätzlich kann die Wärmeleitmatte Partikel aufweisen, welche in beispielsweise dem Kunststoff eingebettet sind. Der Kunststoff der Wärmeleitmatte kann beispielsweise ein thermoplastischer Kunststoff (auch als Thermoplast bezeichnet) sein. Alternativ oder zusätzlich kann der Kunststoff der Wärmeleitmatte elastisch sein, z.B. wenn dieser einen Gummi und/oder Silikon aufweist oder daraus gebildet ist.

Die Wärmeleitpaste kann beispielsweise ein heterogenes Gemisch aufweisen oder daraus gebildet sein. Das heterogene Gemisch kann einen Feststoff (z.B. eine Vielzahl von Partikeln) und ein viskoses (d.h. flüssiges, fließfähiges oder streichbares) Material aufweisen. Beispielsweise kann das viskose Material ein Öl aufweisen oder daraus gebildet sein, z.B. Silikonöl. Beispielsweise kann der Feststoff (z.B. die Feststoffpartikel) Zinkoxid, Aluminium, Kupfer, Graphit und/oder Silber aufweisen oder daraus gebildet sein.

Das Wärmeleitmaterial kann aber auch ein homogenes Gemisch oder eine (bei Raumtemperatur oder höher) flüssige Metalllegierung aufweisen oder daraus gebildet sein.

Die Wärmeleitfähigkeit und/oder die Ausdehnung des Wärmeleitmaterials 902 (in Richtung 105 auch als Dicke bezeichnet) können den von dem Wärmeleitmaterial 902 bereitgestellten thermischen Widerstand beeinflussen.

Beispielsweise kann die Wärmeleitfähigkeit des Wärmeleitmaterials 902 größer sein als ungefähr 1 Watt pro Meter und Kelvin (W/m·K), zum Beispiel mehr als ungefähr 5 W/m·K, zum Beispiel mehr als ungefähr 7,5 W/m·K, zum Beispiel in einem Bereich von ungefähr 1 W/m·K bis ungefähr 10 W/m·K. Alternativ oder zusätzlich kann die Wärmeleitfähigkeit des Wärmeleitmaterials 902 kleiner sein als die Wärmeleitfähigkeit des Gehäusemittelteil 102.

Alternativ oder zusätzlich kann die Dicke des Wärmeleitmaterials 902 (in Richtung 105) kann beispielsweise weniger sein als ungefähr 5 mm (Millimeter), z.B. weniger als ungefähr 2,5 mm, z.B. weniger als ungefähr 1 mm.

Optional kann der thermische Widerstand des Wärmeleitmaterials ein Gefälle aufweisen. In den thermischen Widerstand gehen neben der Wärmeleitfähigkeit auch die Oberfläche und Dicke des Wärmeleitmaterials ein.

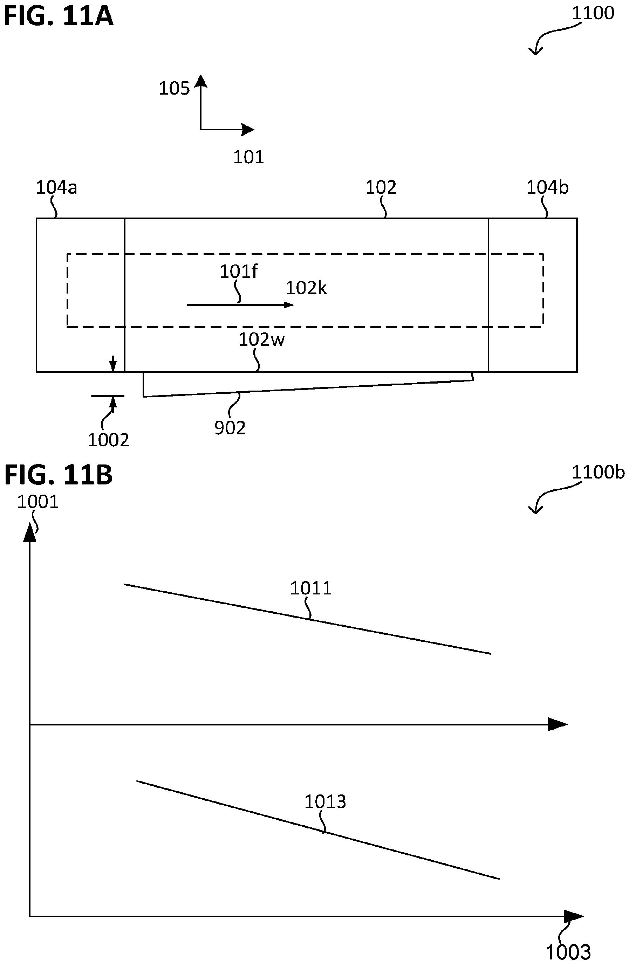

**Fig.11A** veranschaulicht ein Temperierkörpergehäuse 100 gemäß verschiedenen Ausführungsformen 1100 in einer schematischen Seitenansicht oder Querschnittsansicht und **Fig**.**11B** ein schematisches Diagramm 1100b, in welcher eine Wärmeleistungsgröße 1001 über der räumlichen Ausdehnung 1003 in Strömungsrichtung 101f des Temperierfluids aufgetragen ist. Als Wärmeleistungsgröße 1001 ist hier die Wärmeleistungsaufnahme 1011 der Wärmeleistungsaufnahmefläche 102w und ein thermischer Widerstand 1013 des Wärmeleitmaterials 902 angegeben.

Die Wärmeleistungsgröße eines Körpers kann sich auf den Zustand des Körpers beziehen, wenn dieser im thermischen Gleichgewicht ist, d.h. genauso viel Wärmeleistung aufnimmt wie abgibt.

Die Wärmeleistungsaufnahme 1011 des Körpers kann als Maß für die Wärmeleistung, die der Körper aufnimmt, verstanden werden, beispielsweise die im Betrieb aufgenommene Wärmeleistung pro Fläche (quer zum Wärmetransport, d.h. der Konduktion) repräsentierend (z.B. in Watt pro Quadratmeter). Die Wärmeleistungsaufnahme 1011 kann räumlich variieren und/oder vom Ist-Zustand des Betriebs abhängen. Beispielsweise kann die Wärmeleistungsaufnahme 1011 eine Funktion einer räumlich variierenden Wärmeleitfähigkeit des Körpers sein. Beispielsweise kann die Wärmeleistungsaufnahme 1011 eine Funktion einer räumlich variierenden Temperatur des Körpers sein. Beispielsweise kann die Wärmeleistungsaufnahme 1011 eine Funktion einer räumlich variierenden Temperatur des den Körper durchströmenden Fluids sein.

Der thermische Widerstand 1013 des Körpers kann verstanden werden als Maß für die Temperaturdifferenz, die in einem Körper beim Hindurchtreten eines Wärmestromes (Wärme pro Zeiteinheit oder Wärmeleistung) entsteht, und die z.B. als thermische Triebkraft benötigt wird. Der thermische Widerstand 1013 kann räumlich variieren. Der thermische Widerstand 1013 kann beispielsweise eine Funktion einer räumlich variierenden Wärmeleitfähigkeit des Körpers, einer räumlich variierenden Querschnittsfläche (quer zum Wärmetransport) des Körpers, oder einer räumlich variierenden Ausdehnung 1002 des Körpers (entlang des Wärmetransports) sein. Der thermische Widerstand ist eine vom Betrieb unabhängige Größe, und kann optional normiert auf die Temperaturdifferenz angegeben werden. Beispielsweise kann als thermischer Widerstand (auch als Wärmewiderstand bezeichnet) die Ausdehnung 1002 des Körpers (entlang des Wärmetransports) dividiert durch das Produkt aus der Wärmeleitfähigkeit und der Querschnittsfläche, durch welche hindurch die Konduktion erfolgt, verwendet werden. Konduktion bezeichnet den Wärmetransport mittels Wärmeleitung, z.B. gemäß dem Fourierschen Gesetz.

Die Wärmeleistungsaufnahme 1011 der Wärmeleistungsaufnahmefläche 102w kann im Betrieb des Temperierkörpergehäuses 100 ein erstes Gefälle (auch als Wärmeaufnahmegefälle bezeichnet) aufweisen. Das Wärmeaufnahmegefälle kann beispielsweise von dem Kanaleingang des Fluidkanals 102k (z.B. Temperierkanals) zu dem Kanalausgang das Fluidkanals 102k gerichtet sein. Mit anderen Worten kann die Wärmeleistungsaufnahme 1011 der Wärmeleistungsaufnahmefläche 102w entlang der Strömungsrichtung 101f des Temperierfluids abnehmen.

Die Richtung des Gefälles kann verstanden werden als die Richtung, in welche die Wärmeleistungsgröße 1001 abnimmt.

Der thermische Widerstand 1013 des Wärmeleitmaterials 902 kann (z.B. im Betrieb des Temperierkörpergehäuses 100) ein zweites Gefälle (auch als Wärmewiderstandsgefälle bezeichnet) aufweisen. Das Wärmewiderstandsgefälle kann beispielsweise von dem Kanaleingang des Fluidkanals 102k zu dem Kanalausgang des Fluidkanals 102k gerichtet sein. Mit anderen Worten kann der thermische Widerstand entlang der Strömungsrichtung 101f des Temperierfluids abnehmen.

Dies erreicht, dass sich das Wärmewiderstandsgefälle und das Wärmeaufnahmegefälle zumindest teilweise gegenseitig kompensieren. Beispielsweise wird ein hoher Temperaturunterschied bzw. eine hohe Wärmeleistungsaufnahme 1011 durch einen hohen thermischen Widerstand 1013 kompensiert und andersherum.

Der Nettowärmefluss, welcher von der Wärmeleistungsaufnahmefläche 102w durch das Wärmeleitmaterial 902 hindurch aufgenommen wird weist dann ein geringeres Gefälle auf als der thermische Widerstand 1013 und/oder die Wärmeleistungsaufnahme 1011. Dies homogenisiert die Temperierleistung des Temperierkörpergehäuses 100.

Beispielsweise kann das Wärmeleitmaterial 902 einen Gradienten in der Schichtdicke 1002 aufweisen. Dies erreicht ein Wärmewiderstandsgefälle entgegen dem Gradienten in der Schichtdicke 1002.

Beispielsweise kann das Wärmeleitmaterial 902 einen Gradienten in der Wärmeleitfähigkeit aufweisen. Dies erreicht ein Wärmewiderstandsgefälle entlang des Gradienten in der Wärmeleitfähigkeit.

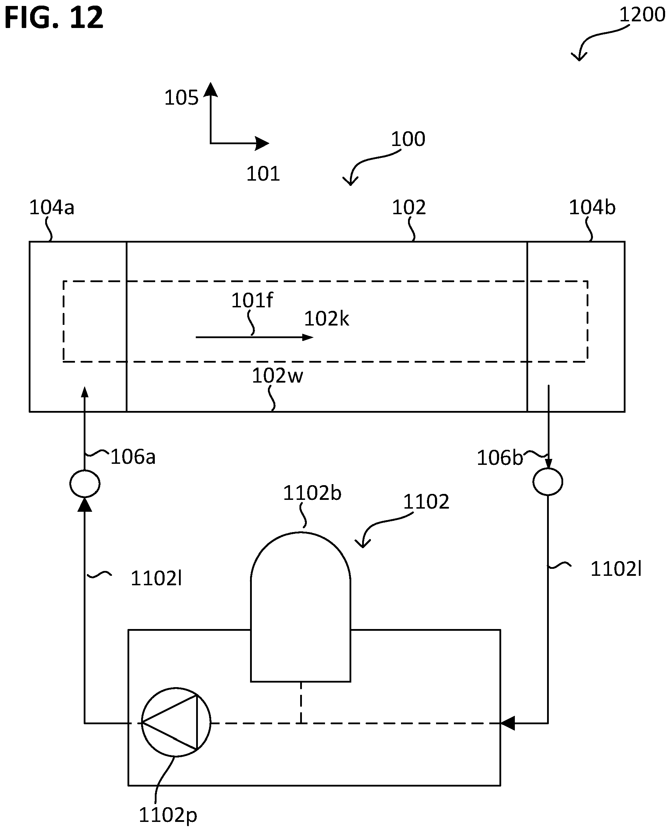

**Fig.12** veranschaulicht eine Temperieranordnung 1200 gemäß verschiedenen Ausführungsformen in einer schematischen Seitenansicht oder Querschnittsansicht. Die Temperieranordnung 1200 weist das Temperierkörpergehäuse 100 und eine Fluidversorgung 1102 auf. Das hierin exemplarisch für einen Prozessor als exemplarisches elektrisches Bauteil Beschriebene kann verstanden werden als, dass das Beschriebene in Analogie auch für andere elektrische Bauteile gelten kann.

Die Fluidversorgung 1102 kann mit den zwei Fluidanschlüssen 106a, 106b des Temperierkörpergehäuses 100 gekoppelt sein. Ferner kann die Fluidversorgung 1102 eingerichtet sein, einen Fluidstrom in Richtung 101f (auch als Strömungsrichtung 101f bezeichnet) durch das Temperierkörpergehäuse 100 hindurch bereitzustellen.

Die Fluidversorgung 1102 kann eingerichtet sein, dem ersten Fluidanschluss 106a das Temperierfluid zuzuführen und dem zweiten Fluidanschluss 106b das Temperierfluid wieder zu entziehen. Das Temperierfluid strömt dann von der ersten Gehäuseendkappe 104a, durch den einen oder mehr als einen Fluidkanal 102k hindurch zu der zweiten Gehäuseendkappe 104b.

Grundsätzlich kann verstanden werden, dass auch ein Fluidstrom entlang eines mäanderförmigen Pfades 101f bereitgestellt werden kann. Dann kann das Temperierfluid mehrmals von der ersten Gehäuseendkappe 104a, durch den einen oder mehr als einen Fluidkanal 102k hindurch zu der zweiten Gehäuseendkappe 104b, und wieder zurückströmen. Hierin wird sich zum einfachen Verständnis auf eine Strömungsrichtung 101f bezogen, was beispielsweise in Analogie für einen Abschnitt des mäanderförmigen Pfades 101f gelten kann (je nach Fließrichtung). Bei einem mäanderförmigen Pfad 101f kann das Fluid auf derselben Seite 102a zugeführt und entzogen werden, z.B. indem eine Endkappe sowohl einen zuführenden Fluidanschluss 106a als auch einen abführenden Fluidanschluss 106b aufweist.

Die Fluidversorgung 1102 kann beispielsweise eine Fluidenergiemaschine 1102p (z.B. eine Pumpe) aufweisen, welche eingerichtet ist, dem Temperierfluid mechanische Arbeit zuzuführen, so dass dieses zum Strömen angeregt wird. Die Fluidversorgung 1102 kann beispielsweise einen Ausgleichsbehälter 1102b aufweisen, welcher eingerichtet ist, das Temperierfluid aufzunehmen und zu bevorraten. Die Fluidversorgung 1102 kann beispielsweise eine oder mehr als eine Fluidleitung (z.B. einen Schlauch) aufweisen, welche die Fluidenergiemaschine mit dem ersten Fluidanschluss 106a und dem zweiten Fluidanschluss 106b fluidleitend verbindet. Die Fluidversorgung 1102 kann beispielsweise ein oder mehr als ein Ventil aufweisen, um den Fluidstrom zu steuern.

Die Fluidenergiemaschine 1102p kann beispielsweise eine Steuervorrichtung aufweisen, welche eingerichtet ist, auf Grundlage einer Temperatur den Durchfluss des Temperierfluids zu steuern und/oder regeln.

Der Begriff "Steuervorrichtung" kann als jede Art einer Logik implementierenden Entität verstanden werden, die beispielsweise eine Verschaltung und/oder einen Prozessor aufweisen kann, welche beispielsweise Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein. Die Steuervorrichtung kann beispielsweise eine speicherprogrammierbare Steuervorrichtung (SPS) aufweisen oder daraus gebildet sein.

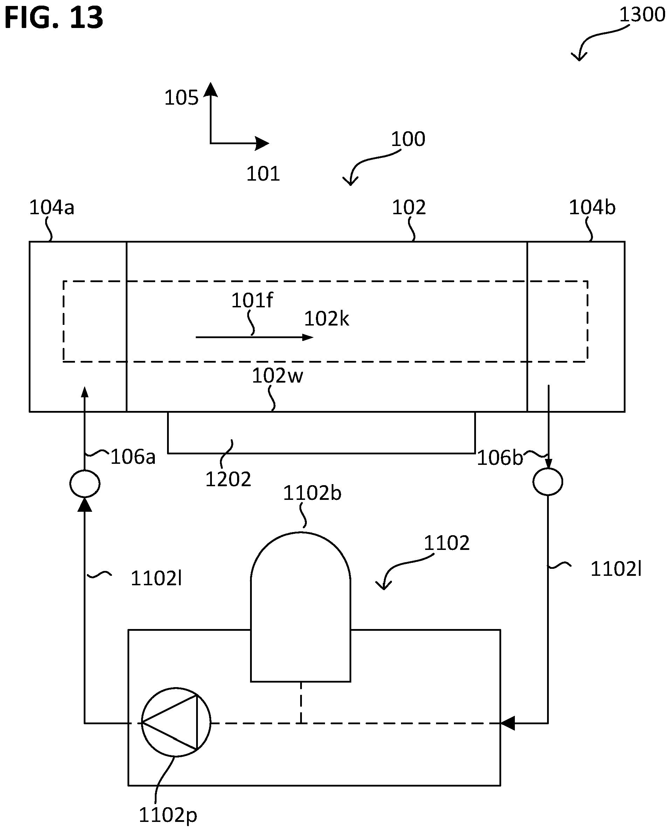

**Fig.13** veranschaulicht eine elektrische Vorrichtung 1300 gemäß verschiedenen Ausführungsformen in einer schematischen Seitenansicht oder Querschnittsansicht. Die elektrische Vorrichtung weist das Temperierkörpergehäuse 100 und ein oder mehr als ein elektrisches Bauteil 1202 auf, z.B. einen oder mehr als einen Prozessor 1202. Die elektrische Vorrichtung 1300 kann beispielsweise Teil einer Rechenvorrichtung sein, z.B. eines Servers oder Ähnlichem.

Das hierin exemplarisch für konkrete elektrische Bauteile Beschriebene kann verstanden werden als, dass dies in Analogie auch für andere elektrische Bauteile 1202 gelten kann. Grundlegend können aber auch andere elektrische Bauteile 1202 mittels des Temperierkörpergehäuses 100 gekühlt werden (d.h., dass diesen thermische Energie entzogen wird).

Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit 1529 (GPU), einen digitalen Signalprozessor (DSP), eine programmierbare Gatter-Anordnung (FPGA), eine integrierte Schaltung, aktive oder passive Bauteile die ggf. gekühlt werden (z.B. MOSFETs, RAM, etc.) oder eine beliebige Kombination davon aufweisen oder daraus gebildet sein.

Die elektrische Vorrichtung 1300 kann optional die Fluidversorgung 1102 aufweisen, welche mit den zwei Fluidanschlüssen 106a, 106b des Temperierkörpergehäuses 100 gekoppelt ist.

Im Folgenden werden weitere Aspekte gemäß verschiedenen Ausführungsformen beschrieben, für welche die oben beschriebenen Aspekte in Analogie gelten können, z.B. für das im Folgenden beschriebene Temperiermodul. Das im Folgenden beschriebene Temperiermodul ist ein Vergleichsbeispiel und kann im Allgemeinen aufweisen: mehrere (z.B. freiliegende und/oder ebene) Temperierelement (z.B. Temperierkörper); und eine Fluidleitung, welche einen ersten Fluidanschluss (anschaulich auch als Fluideintritt bezeichnet) und einen zweiten Fluidanschluss (anschaulich auch als Fluidaustritt bezeichnet) aufweist; wobei die mehreren Temperierelement in einem Abstand voneinander mittels der Fluidleitung gehalten (z.B. in dieser eingebettet) sind (beispielsweise so dass diese paarweise mittels eines Abschnitts der Fluidleitung voneinander separiert sind und/oder miteinander fluidleitend gekoppelt sind); wobei die mehreren Temperierelement eine größere Wärmeleitfähigkeit aufweisen als die Fluidleitung und/oder wobei sich die mehreren Temperierelement in ihrer Wärmeleitfähigkeit voneinander unterscheiden. Beispielsweise kann die Fluidleitung einen Strömungspfad von dem ersten Fluidanschluss zu dem zweiten Fluidanschluss bereitstellen, welcher an jedem der mehreren Temperierelement vorbei und/oder durch diese hindurch führt. Beispielsweise kann die Fluidleitung als tragende Struktur ausgebildet sein (d.h. deren Material kann starr, ein Duroplast und/oder ein Thermoplast sein). Beispielsweise kann die Fluidleitung eine oder mehr als eine Montagestruktur aufweisen (z.B. Durchgangsöffnungen). Beispielsweise kann die Fluidleitung monolithisch ausgebildet sein oder zwei zusammengefügte Halbschalen aufweisend oder daraus gebildet sein, wobei beispielsweise zumindest eine der zwei Halbschalen monolithisch ist und/oder die mehreren Temperierelement trägt. Beispielsweise kann die Fluidleitung und/oder kann zumindest einer der mehreren Temperierelement einen Kunststoff aufweisen oder daraus gebildet sein. Beispielsweise kann zumindest einer der mehreren Temperierelement ein Metall (z.B. hoch-wärmeleitfähiges Metall) aufweisen oder daraus gebildet sein (z.B. Kupfer). Der Temperierelement des Temperiermoduls kann aber muss nicht notwendigerweise ein Temperierkörpergehäuse aufweisen.

Beispielsweise kann jeder der mehrere Temperierelement eine (z.B. freiliegende und/oder ebene) Wärmeleistungsaufnahmefläche (auch als Funktionsfläche bezeichnet) aufweisen, welche beispielsweise von der Fluidleitung hervorsteht.

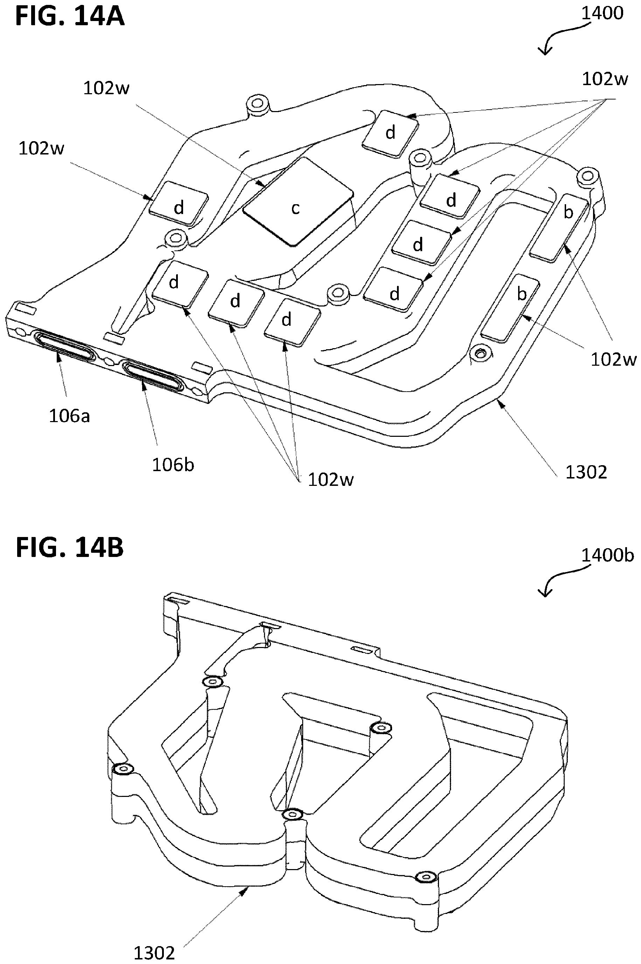

**Fig.14A** veranschaulicht ein Temperiermodul 1400 gemäß einem Vergleichsbeispiel, welches nicht die Erfindung repräsentiert, in einer schematischen Perspektivansicht von unten und **Fig.14B** das Temperiermodul 1400 in einer schematischen Perspektivansicht 1400b von oben.

Das Temperiermodul 1400 kann mehrere freiliegende Wärmeleistungsaufnahmeflächen 102w aufweisen, z.B. jedes mittels einer Wärmeaufnahmeplatte oder eines Temperierkörpergehäuses 100 bereitgestellt. Ferner weist das Temperiermodul 1400 eine Fluidleitung 1302 auf, welche einen Fluidströmungspfad an den mehreren Wärmeleistungsaufnahmeflächen 102w vorbei bereitstellt (z.B. in Reihe).

Eine Vielzahl elektrischer Bauteile (im Folgenden Bauteile genannt) kann für ihre (optimale) Funktionalität eine gezielte aktive Temperierung (z.B. Kühlung und/oder Heizung aufweisend) entsprechend individueller Bauteileigenschaften erfordern. Maßgebliche Bauteileigenschaften sind dabei Betriebstemperatur (minimal/maximal/optimal) und elektrische/thermische Leistung. Die Temperierung kann dabei sowohl innere thermische Lasten der Bauteile (z.B. Energieumwandlung innerhalb elektronischer Bauteile) als auch extern aufgeprägte thermische Beeinflussungen der Bauteile berücksichtigen (z.B. strahlungs- und/oder konvektive Wärmeübertragung zwischen Bauteil und Umgebung). Technische Bauteilgruppen und Systeme bestehen in der Regel aus einer Vielzahl Bauteilen als Einzelkomponenten.

Die Betriebstemperatur der Bauteile haben in vielen Fällen globale Auswirkungen auf entscheidende Parameter wie Betriebsfähigkeit, Energieeffizienz, Lebensdauer und Leistungsfähigkeit des gesamten Systems. Eine gezielte aktive Temperierung bestimmter Bauteile oder Bauteilgruppenbereiche durch einen fluiddurchströmtes Temperiermodul 1400 ist daher bei vielen Anwendungen hilfreich. Das Temperiermodul 1400 kann eine oder mehr als eine der folgenden Eigenschaften aufweisen:
- Realisierung optimaler Betriebstemperaturen für alle aktiv temperierten Bauteile des technischen Systems, z.B. entsprechend der individuellen Bauteileigenschaften; und/oder
- maximale thermische Effizienz des Temperiermoduls, d.h. minimale Energieverluste bei der Wärmeübertragung zwischen Bauteilen und Fluid

Optional erfolgt die Temperierung technischer Bauteilgruppen durch eine großflächige Kontaktierung der aktiv zu temperierenden Bauteilgruppenbereiche bzw. - Bauteile mittels einer oder mehr als einer thermischen Funktionsfläche 102w des Temperiermoduls 1400. Die thermischen Funktionsflächen 102w des Temperiermoduls 1400 weisen einen hoch-wärmeleitfähigen Werkstoffen (in der Regel Metalle wie Aluminium und Kupfer) auf oder sind daraus gebildet. Dadurch wird die Wärmeübertragung zwischen aktiv temperierten Bauteilgruppenbereich bzw. -Komponenten und Fluid realisiert. Eine thermische Funktionsfläche 102w kontaktiert dabei ein oder mehr als ein Bauteil bzw. einen oder mehr als einen Bereich der Bauteilgruppe. Die Fluidführung erfolgt mittels eines Gehäuses, dessen Werkstoff gleich oder verschieden dem der thermischen Funktionsfläche sein kann.

Der großflächige Einsatz eines homogenen Werkstoffs für die eine oder mehr als eine thermische Funktionsfläche 102w (im Zusammenhang mit der Wärmeaufnahme auch als Wärmeleistungsaufnahmefläche bezeichnet) des Temperiermoduls 1400 hat zur Folge, dass unter Umständen nicht alle individuellen thermischen Bauteileigenschaften hinreichend berücksichtigt werden. Beispielsweise werden Bauteile mit geringer Leistungsdichte mit dem identischen Werkstoff angebunden, wie Bauteile mit vielfach höherer Leistungsdichte. Dadurch ist nicht notwendigerweise eine bedarfsgerechte Temperierung von individuellen Bauteilgruppenbereiche und Bauteile, entsprechend deren Bauteileigenschaften, gegeben.

Mit anderen Worten werden nicht notwendigerweise optimale individuelle Bauteiltemperaturen realisiert. Durch den großflächigen Einsatz hoch-wärmeleitfähigen Materials an der Funktionsfläche 102w wird ferner eine gegenseitige thermische Beeinflussung von räumlich nah aneinander liegenden Bauteilen bzw. Bauteilgruppenbereichen (auch als "thermische Verschmierung" bezeichnet) begünstigt. Beispielsweise erfolgt eine ungewollte Wärmeübertragung von Bauteilen hoher Leistungsdichte und Temperaturverträglichkeit zu Bauteilen niedrigerer Leistungsdichte und Temperaturverträglichkeit.

Durch beide oben beschriebenen Effekte kann eine nicht bedarfsgerechte Temperierung von Bauteilen bzw. Bauteilgruppenbereichen begünstigt werden. Dies führt zu unerwünschten Einbußen der optimalen Betriebsfähigkeit, Energieeffizienz, Lebensdauer und Leistungsfähigkeit der Bauteile und/oder der Bauteilgruppe. Beim Betrieb des Temperiermoduls 1400 treten indirekte Wärmeübertragungsprozesse (konduktiv, konvektiv, Wärmestrahlungs-Absorption bzw. -Emission) in Bereichen des Temperiermoduls 1400 auf, welche keine direkte thermische Kontaktierung zwischen aktiv temperierten Bauteilen bzw. Bauteilgruppenbereichen und der thermischen Funktionsfläche 102w aufweisen. So finden beispielsweise Wärmeübertragungsprozesse zwischen Temperiermodul 1400 und Umgebungsmedium und/oder umgebenden Festkörpern (Elektronikbauteilen, Leiterplatten, Gehäusebauteilen etc.) statt.

Bei einem Temperiermodul 1400, welches aus einem homogenen Werkstoffsystem besteht, können die beschriebenen indirekten Wärmeübertagungsprozesse nicht gehemmt werden. So wird beispielsweise Wärme über die thermische Funktionsfläche 102w auch in Bereichen des Temperiermoduls 1400 übertragen, die keinen Kontakt mit den temperierten Bauteilen ausweisen. Die beschriebenen Effekte beeinträchtigen die Gesamteffizienz und die Funktion des Temperiermoduls.

Hoch-wärmeleitfähige Werkstoffe sind in der Regel ebenfalls gute elektrische Leiter. Daher erfolgt der großflächige Einsatz von hoch elektrisch-leitfähigen Materialien durch die thermische(n) Funktionsfläche(n) 102w. Elektrisch hoch leitfähige Werkstoffe befinden sich demnach oft in unmittelbarer Nähe elektrisch nicht isolierter Komponenten des zu temperierenden (z.B. kühlenden) Bauteils. Dadurch entsteht ein erhöhtes Risikopotential für elektrische Kurzschlüsse, woraus die Notwendigkeit einer aufwendigen Montage und Qualitätskontrolle, bzw. die Implementierung von Maßnahmen zur Vermeidung von elektrischen Kurzschlüssen, beispielsweise durch die Verwendung von Isolationsmaterial resultiert.

Das Temperiermodul 1400 weist eine bedarfsgerechte Werkstoffauswahl in definierten Bereichen des Temperiermoduls auf entsprechend der benötigten technischen Funktionalität. Dies wird durch die Verwendung eines Werkstoffverbundsystems realisiert. Unterschiedliche Bereiche können dabei beispielsweise die folgenden Funktionalitäten bzw. Kombinationen aus diesen besitzen:
- hoch-wärmeleitfähig oder gering wärmeleitfähig;
- elektrisch leitend oder elektrisch isolierend;
- mechanisch belastet oder mechanisch unbelastet.

Größe, geometrische Form und Material der thermischen Funktionsflächen 102w entspricht dabei dem individuellen Bedarf der zu temperierenden (z.B. kühlenden) Bauteile (entsprechend Abmessungen und Form der temperierten Bauteile bzw. Bauteilbereiche). Bereiche des Temperiermoduls 1400 (z.B. die Fluidleitung), welche keine direkte Anbindung mit zu temperierenden Bauteilen besitzen können aus gering-wärmeleitfähigem Material gefertigt werden.

Eine oder mehr als eine thermische Funktionsfläche 102w kann beispielsweise in die Fluidleitung 1302 eingeklebt sein, von einer Fluidleitung (z.B. mittels Spritzgusses hergestellt) aus Kunststoff stirnseitig umschlossen ("umspritzt") sein, oder mit einer Dichtung, beispielsweise aus einem Elastomer gefertigt, formschlüssig geklemmt sein. Mehrere thermische Funktionsflächen 102w eines Temperiermoduls können mittels der gering wärmeleitenden Fluidleitung 1302 voneinander thermisch isoliert.

Dies erreicht eine geringe gegenseitige thermische Beeinflussung, d.h. hemmt die "thermische Verschmierung". Dies erreicht eine bedarfsgerechte Temperierung einzelner Bauteile bzw. Bauteilbereiche. Dies verbessert ferner die Energieeffizienz und die Leistungsfähigkeit und vergrößert die Lebensdauer der temperierten Einzelkomponenten und des gesamten technischen Systems. Dies minimiert darüber hinaus das Risiko für elektrische Kurzschlüsse. Dies maximiert auch die thermische Effizienz des Temperiermoduls 1400, beispielsweise durch die Minimierung indirekter Wärmeübertragung.

Das Temperiermodul 1400 weist somit eine bedarfsgerechte Werkstoffauswahl auf mittels eines Materialverbundsystems, und erreicht dadurch unterschiedliche Funktionalitäten an definierten Stellen/Positionen des fluiddurchströmten Temperiermoduls 1400.

Das Temperiermodul 1400 kann beispielsweise zur Temperierung (z.B. Kühlung) einer Grafikkarte verwendet werden. Die Grafikkarte weist mehrere zu temperierende Bereiche auf, entsprechend der Bauteile auf ihrer Leiterplatte, welche unterschiedliche Anforderungen in Bezug auf ihre Temperierung (z.B. Kühlung) stellen. Diesen Anforderungen wird in der Konstruktion Rechnung getragen.

Beispiele für aktiv zu temperierende Bauteile weisen auf: Grafikprozessor (engl: "graphics processing unit" - GPU), welches ein Bauteil mit hoher thermischen Leistungsdichte und hoher Temperaturverträglich ist; Speichermedien (z.B. Random-access memory - RAM), welches Bauteile mit geringer thermischer Leistungsdichte und geringer Temperaturverträglichkeit sind; Spannungswandler 1529 (engl: "voltage regulation module" - VRM), welcher ein Bauteil mit mittlerer thermischer Leistungsdichte und hoher Temperaturverträglichkeit ist.

Mehrere (z.B. alle) aktiv zu temperierenden Bauteile können entsprechend der Größe ihrer wärmeübertragenden Oberfläche mit hoch-wärmeleitfähigen Kupferstrukturen 102w thermisch an das Temperiermodul 1400 angebunden (z.B. konduktiv mit diesem gekoppelt) sein. Die Fluidleitung 1302 kann aus thermisch gering leitendem Kunststoff sein. Das Temperierkörpergehäuse 100 fixiert die Kupferstrukturen 102w mechanisch. Mittels der Fluidleitung 1302 wird eine thermische Entkopplung zwischen der hoch-leistungsdichten und hoch-temperaturverträglichen GPU 1528 und den temperaturempfindlichen RAM-Modulen realisiert.

Im Betrieb sind die Kupferstrukturen (b) mit den Spannungswandlern (VRM) thermisch gekoppelt, die Kupferstrukturen (c) mit der GPU 1528 thermisch gekoppelt und die Kupferstrukturen (d) mit dem RAM-Modulen thermisch gekoppelt.

Daher wird eine thermische Beeinflussung der temperaturempfindlichen RAM-Module durch die GPU 1528 gehemmt. Durch denselben Mechanismus erfolgt die thermische Entkopplung zwischen leistungsdichten Spannungswandlern (Betrieb auf hohem Temperaturniveau) und den temperaturempfindlichen RAM-Modulen. Alle Bereiche des Temperiermoduls, welche nicht für die aktive Temperierung eingesetzt werden, können beispielsweise aus gering wärmeleitfähigem Kunststoff gefertigt sein. Dies führt zu geringer indirekter Wärmeübertragung zwischen Fluid und Umgebungsbereichen, woraus eine hohe Effizienz des Temperiermoduls resultiert.

Das Temperiermodul 1400 weist ferner einen Fluideinlass 106a und Fluidauslass 106b auf, welche mittels Öffnungen in der Fluidleitung bereitgestellt sind.

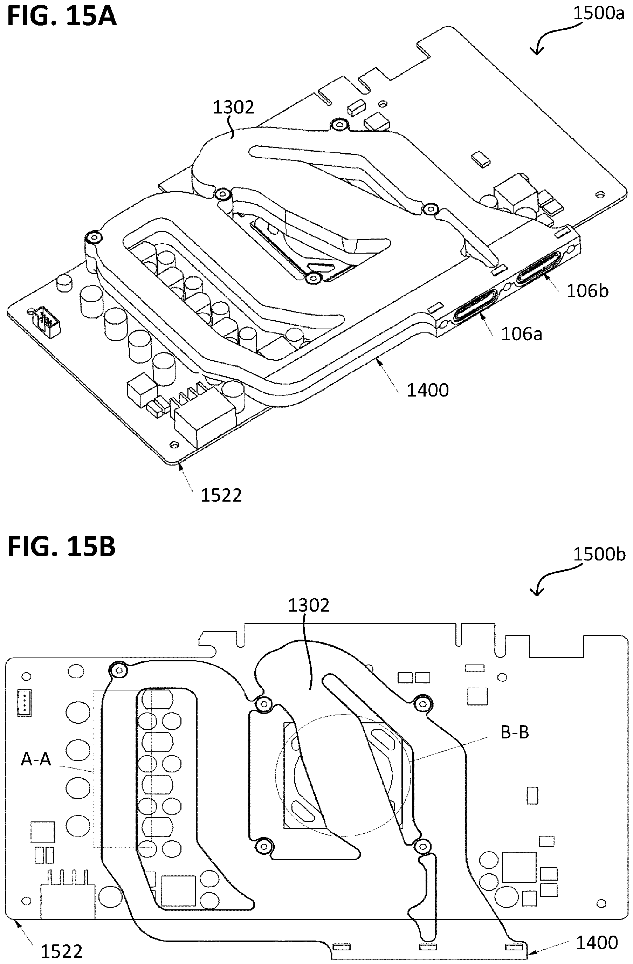

**Fig.15A** veranschaulicht eine elektrische Vorrichtung 1300 gemäß einem Vergleichsbeispiel, welches nicht die Erfindung repräsentiert, welche das Temperiermodul 1500 und eine Leiterplatte 1522 aufweist, in einer schematischen Perspektivansicht 1500 von oben und **Fig.15B** das Temperiermodul 1500 in einer schematischen Draufsicht 1500b von oben. Das Temperiermodul 1500 kann auf die Leiterplatte 1522 eines elektrischen Bauteils (z.B. einer Grafikkarte) montiert sein.

Optional können nur zu temperierende (z.B. kühlende) Komponenten des elektrischen Bauteils von dem Temperiermodul bedeckt werden.

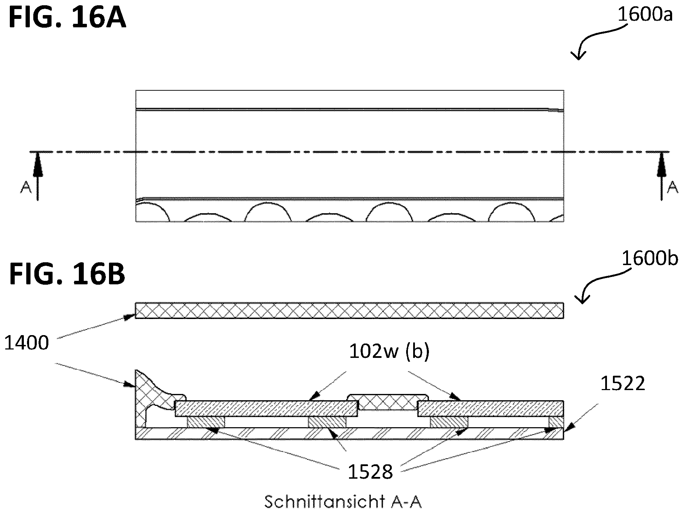

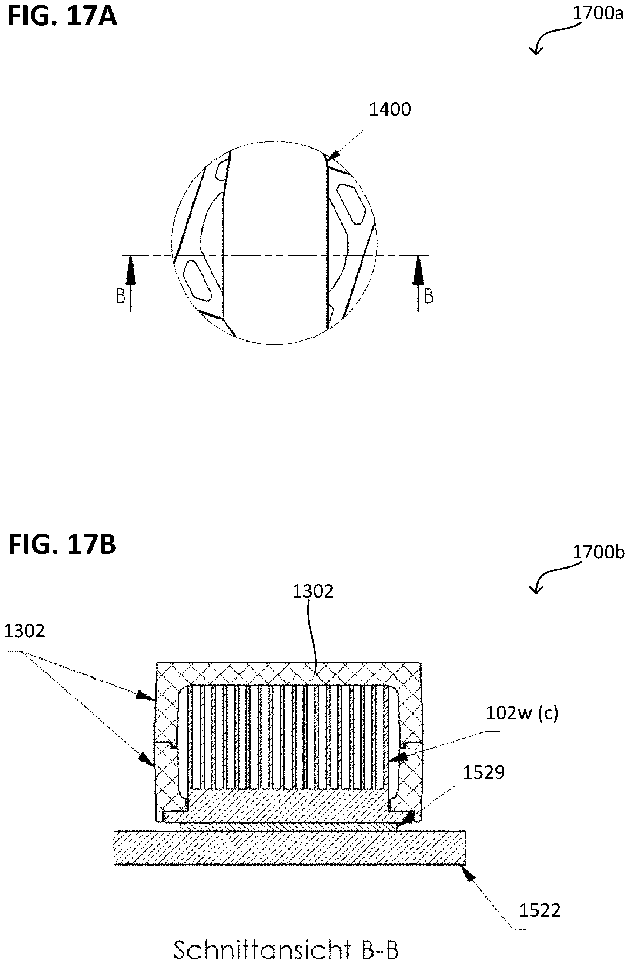

**Fig.16A** bis **Fig.17B** veranschaulichen die Schnittansichten A-A und B-B der elektrische Vorrichtung 1300 gemäß einem Vergleichsbeispiel, welches nicht die Erfindung repräsentiert, in verschiedenen schematischen Ansichten 1600a bis 1700b (Detail- une Schnittansichten).

Die Detail- und Schnittansichten 1600a, 1600b zeigen die eingesetzten Kupferstrukturen 102w (b) und (c). Diese sind beispielsweise mittels einer Klebeverbindung oder einer stirnseitigen Umschließung mit Kunststoff in der Fluidleitung 1302 fixiert. Die Kupferstrukturen 102w liegen direkt auf den zu temperierenden (z.B. kühlenden) Komponenten des Bauteils auf oder zwischen diesen kann auch ein Wärmeleitmaterial 902 (engl: "thermal interface material"), z.B. Wärmeleitpaste, Wärmeleitpad, zur thermischen Anbindung eingerichtet sein.

Die Gegenseite der Kupferstrukturen 102w können im Betrieb in direktem Kontakt zum Fluid sein bzw. direkt vom Fluid umströmt werden.

Dies erreicht eine hohe Energieeffizienz des Temperiermoduls, da eine mittels eines geringwärmeleitfähigen Kunststoffs thermisch gedämmte Fluidleitung 1302 bereitgestellt wird. Dies erreicht ferner eine optimale individuelle Bauteiltemperatur durch thermische Entkopplung der Bauteile und bedarfsgerechte Temperierung durch individuelle thermische Anbindung. Dies erreicht weiterhin eine Minimierung des Risikos elektrischer Kurzschlüsse durch den Einsatz elektrisch isolierenden Materials zwischen den thermischen Funktionsflächen 102w.

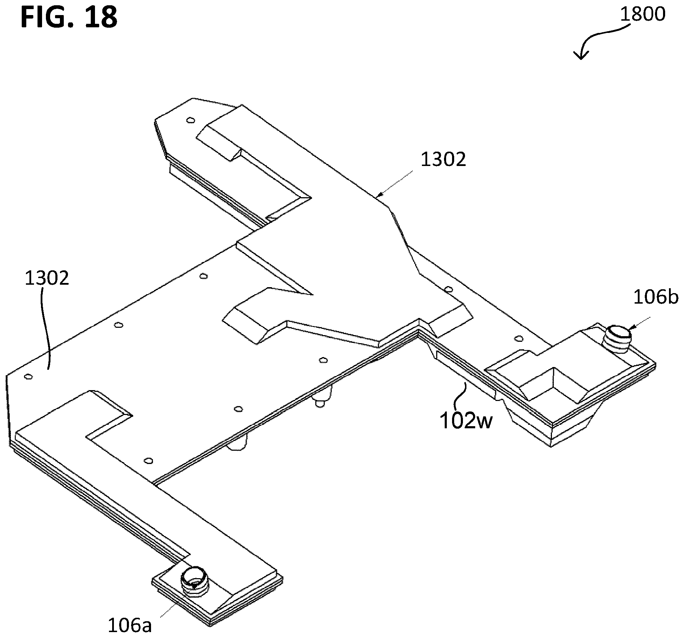

**Fig.18** veranschaulicht ein Temperiermodul 1400 gemäß einem Vergleichsbeispiel 1800, welches nicht die Erfindung repräsentiert, in einer schematischen Perspektivansicht.

Das Temperiermodul 1400 gemäß Vergleichsbeispiel 1800 erreicht die Temperierung (z.B. Kühlung) eines Motherboards (z.B. Server-Mainboards). Das Motherboard weist Bauteile mit unterschiedlicher thermischer Leistung bzw. Leistungsdichte und Temperaturverträglichkeit auf, welche folglich verschiedene Anforderungen an ihre Temperierung aufweisen.

Beispiele für aktiv zu temperierende Bauteile weisen auf: Zentralprozessor (engl: "central processing unit" - CPU), welcher ein Bauteil mit hoher thermischen Leistungsdichte und hoher Temperaturverträglich ist, Spannungswandler, welcher ein Bauteil mittlerer thermischer Leistungsdichte und hoher Temperaturverträglichkeit ist; Kommunikationsprozessor, welcher ein Bauteil geringer thermischer Leistungsdichte und geringer Temperaturverträglichkeit ist.

Die Grundstruktur des Wassertemperierungssystems 1400 besteht aus einer Fluidleitung 1302 aus Kunstsoff (welche eine geringe Wärmeleitfähigkeit aufweist). Die Anbindung von Spannungswandlern und Kommunikationschips ist mittels mehrerer Wärmeleistungsaufnahmeflächen 102w aus wärmeleitfähigem Kunststoff bereitgestellt (welcher eine mittlere Wärmeleitfähigkeit aufweist). Die thermische Anbindung der CPU erfolgt mittels einer Wärmeleistungsaufnahmefläche 102w aus Kupfer (welche eine hohe Wärmeleitfähigkeit aufweist).

Das Temperiermodul 1400 gemäß Vergleichsbeispiel 1800 erreicht eine hohe Energieeffizienz, da eine thermisch gedämmte Fluidleitung aus geringwärmeleitfähigem Kunststoff verwendet wird; erreicht ferner eine optimale individuelle Bauteiltemperatur durch thermische Entkopplung der Bauteile und bedarfsgerechte Temperierung durch individuelle thermische Anbindung; erreicht weiterhin eine Minimierung des Risikos elektrischer Kurzschlüsse durch den Einsatz elektrisch isolierenden Materials zwischen den thermischen Funktionsflächen 102w.

In einem Beispiel besteht die Grundstruktur des Temperiermoduls 1400 aus einer Fluidleitung 1302 aus Kunststoff 1 (d.h. mit geringer Wärmeleitfähigkeit). Der Fluideintritt 106a und der Fluidaustritt 106b sind in der Fluidleitung 1302 integriert.

Die Anbindung von Spannungswandlern und Kommunikationschips ist mittels Funktionsflächen 102w aus wärmeleitfähigem Kunststoff (e) (d.h. eine mittlere Wärmeleitfähigkeit aufweisend) bereitgestellt.

Die thermische Anbindung der CPU erfolgt mittels einer Funktionsflächen 102w aus einer Kupferstruktur (f) (d.h. eine hohe Wärmeleitfähigkeit aufweisend).

Die Kupferstruktur kann direkt auf dem zu temperierenden (z.B. kühlenden) Bauteil 1515 aufliegen oder zwischen diesen kann auch ein Wärmeleitmaterial 902, z.B. Wärmeleitpaste, Wärmeleitpad, zur thermischen Anbindung eingerichtet sein. Die Gegenseite der Kupferstrukturen 102w können im Betrieb in direktem Kontakt zum Fluid sein bzw. direkt vom Fluid umströmt werden.

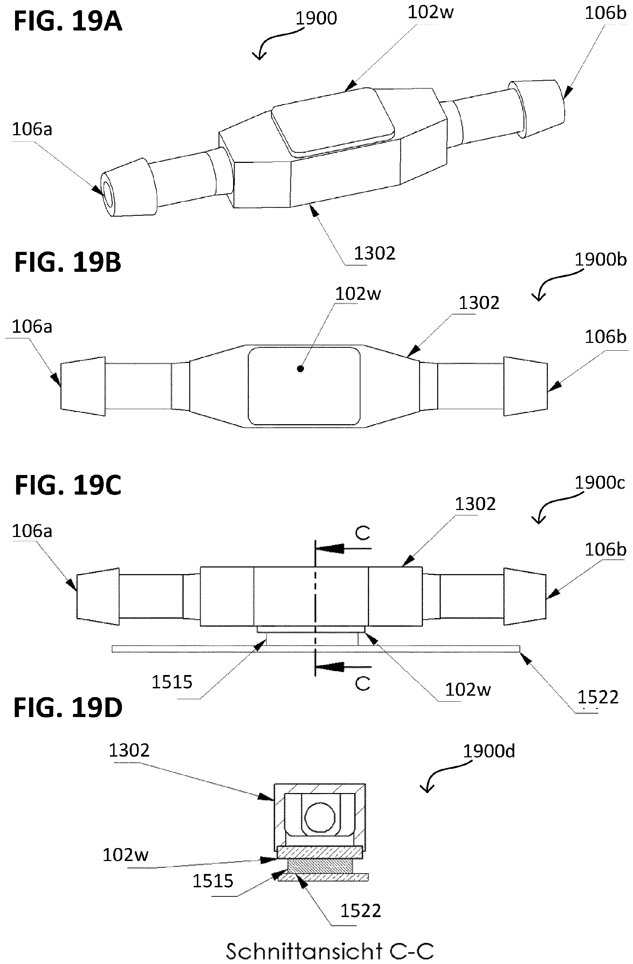

**Fig.19A** veranschaulicht ein Temperiermodul 1400 gemäß einem Vergleichsbeispiel 1900, welches nicht die Erfindung repräsentiert, in einer schematischen

Perspektivansicht und **Fig.19B** bis **Fig.19D** das Temperiermodul 1400 in zusätzlichen schematischen Ansichten. Das Temperiermodul 1400 gemäß Vergleichsbeispiel 1900 erleichtert die Temperierung (z.B. Kühlung) von peripheren Elektronikkomponenten und muss nicht notwendigerweise mehrere Funktionsflächen 102w aufweisen. Die Fluidleitung 1302 kann in Form eines Gehäuses bereitgestellt sein, in welches die Funktionsfläche(n) 102w eingebettet ist/sind.

Das Temperiermodul 1400 weist die Fluidleitung 1302 (aus einem Kunststoff gebildet) auf, der einen Fluideinlass 106a und Fluidauslass 106b aufweist. Die thermische Funktionsfläche 102w kann mittels einer flachen Kupferstruktur bereitgestellt werden.

Das Temperiermodul 1400 kann auf einer Leiterplatte 1522 mit zu temperierendem (z.B. kühlendem) Chip 1515, respektive Elektronikbauteil 1515, montiert sein oder werden. Die Kupferstruktur kann mittels Einklebens bzw. stirnseitiger Umhüllung durch den Kunststoff der Fluidleitung 1302 befestigt sein. Die Kupferstruktur kann direkt auf dem zu temperierenden (z.B. kühlenden) Bauteil 1515 aufliegen oder zwischen diesen kann auch ein Wärmeleitmaterial 902, z.B. Wärmeleitpaste, Wärmeleitpad, zur thermischen Anbindung eingerichtet sein.

Die Gegenseite der Kupferstrukturen 102w können im Betrieb in direktem Kontakt zum Fluid sein bzw. direkt vom Fluid umströmt werden.

Das Temperiermodul 1400 erreicht eine höhere Energieeffizienz, beispielsweise wenn die thermisch gedämmte Fluidleitung 1302 aus gering-wärmeleitfähigem Kunststoff bereitgestellt wird.

Das Temperiermodul 1400 erreicht eine Minimierung des Potentials elektrischer Kurzschlüsse durch den Einsatz elektrisch isolierenden Materials zwischen für die Fluidleitung 1302.

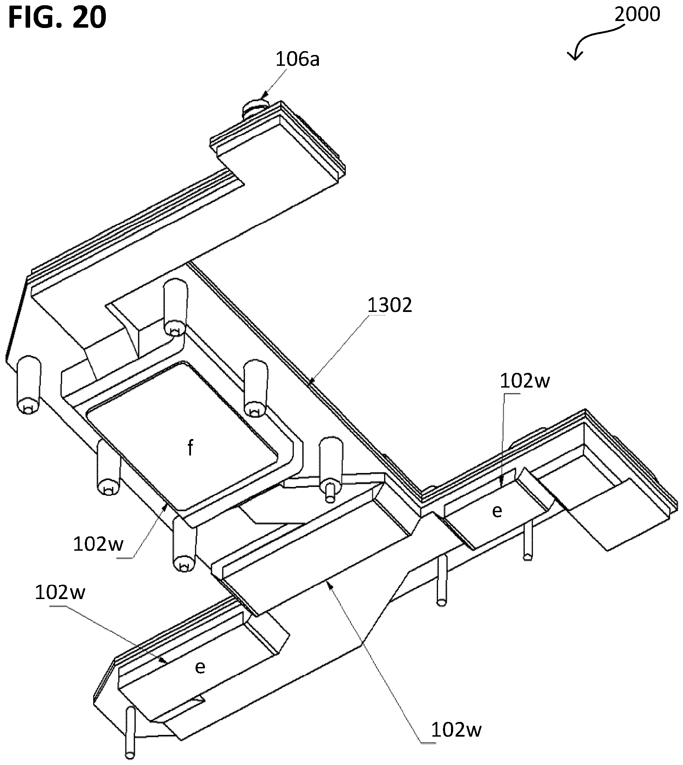

**Fig.20** veranschaulicht ein Temperiermodul 1400 gemäß einem Vergleichsbeispiel 2000, welches nicht die Erfindung repräsentiert, in einer schematischen Perspektivansicht.

**Fig.21** veranschaulicht ein Temperierkörpergehäuse 100 gemäß verschiedenen Ausführungsformen 2100 in einer schematischen Draufsicht oder Querschnittsansicht. Das Temperierkörpergehäuse weist auf: einen monolithischen Gehäusemittelteil 102, eine erste Gehäuseendkappe 104a und eine zweite Gehäuseendkappe 104b.

Die erste Gehäuseendkappe 104a weist den ersten Fluidanschluss 106a und den zweiten Fluidanschluss 106b auf. Der Gehäusemittelteil 102 ist von einem oder mehr als einem Paar Fluidkanälen 102k (aus zwei nebeneinander angeordneten Fluidkanälen 102k gebildet) durchdrungen, von denen jedes Paar Fluidkanäle 102k den ersten Fluidanschluss 106a und den zweiten Fluidanschluss 106b fluidleitend miteinander verbindet, z.B. durch die zweite Gehäuseendkappe 104b (z.B. deren Hohlraum 108h) hindurch.

Die erste Gehäuseendkappe 104a kann beispielsweise eine Trennwand 108t aufweisen, welche zwischen dem ersten Fluidanschluss 106a und dem zweiten Fluidanschluss 106b angeordnet ist (diese beispielsweise räumlich voneinander separierend) und/oder welche den Gehäusemittelteil 102 berührt. Beispielsweise kann die erste Gehäuseendkappe 104a zwei Hohlräume 108h (mittels der Trennwand voneinander separiert) aufweisen, von denen ein erster Hohlraum 108h den ersten Fluidanschluss 106a mit dem ersten Fluidkanal des Paars Fluidkanäle 102k fluidleitend verbindet und von denen ein zweiter Hohlraum 108h den zweiten Fluidanschluss 106b mit dem zweiten Fluidkanal des Paars Fluidkanäle 102k fluidleitend verbindet.

Das oder jedes Paar Fluidkanäle 102k kann eine Umlenkung des Strömungspfads 101f innerhalb des Temperierkörpers 100 ermöglichen, z.B. innerhalb der zweiten Gehäuseendkappe 104b. Mit anderen Worten können sich die Fluidkanäle des Paars Fluidkanäle 102k voneinander unterscheiden in der bereitgestellten Strömungsrichtung 101f. Der Strömungspfad 101f kann beispielsweise durch die zweite Gehäuseendkappe 104b hindurch erstreckt sein.

Analog zum vorstehenden erstreckt sich jeder Fluidkanal des Paars Fluidkanäle 102k von einer ersten Seite 102a (z.B. Stirnseite) des Gehäusemittelteils 102 zu einer zweiten Seite 102b (z.B. Stirnseite) des Gehäusemittelteils 102 durch den Gehäusemittelteil 102 hindurch (entlang Richtung 101).

Das hierin für den monolithischen Gehäusemittelteil Beschriebene kann in Analogie für einen mehrteiligen Gehäusemittelteil gelten, der gemäß verschiedenen Vergleichsbeispielen beispielsweise zwei oder mehr Gehäusemittelteil-Bestandteile (z.B. Halbschalen) aufweist oder daraus gebildet ist, wobei die Gehäuseendkappen nicht zwingend erforderlich sind, z.B. wenn die Fluidanschlüsse in den Halbschalen integriert sind. Die einen oder mehr als einen wärmeübertragende Fläche des Gehäusemittelteils kann optional aus einem anderen Material sein wie tragende Struktur des Gehäusemittelteils.

Jeder der zwei Gehäusemittelteil-Bestandteile kann beispielsweise ein Strangpressprodukt sein, Aluminium aufweisen oder daraus gebildet sein und/oder Kunststoff aufweisen oder daraus gebildet sein.

Es kann verstanden werden, dass alternativ zu den hierin beschriebenen Gehäuseendkappen, von denen jede Gehäuseendkappe einen Fluidanschluss aufweist, die zwei Gehäuseendkappen verwendet können, von denen (z.B. nur) die erste Gehäuseendkappe zwei Fluidanschlüsse (und z.B. die zweite Gehäuseendkappe weniger oder keine Fluidanschlüsse) aufweist.

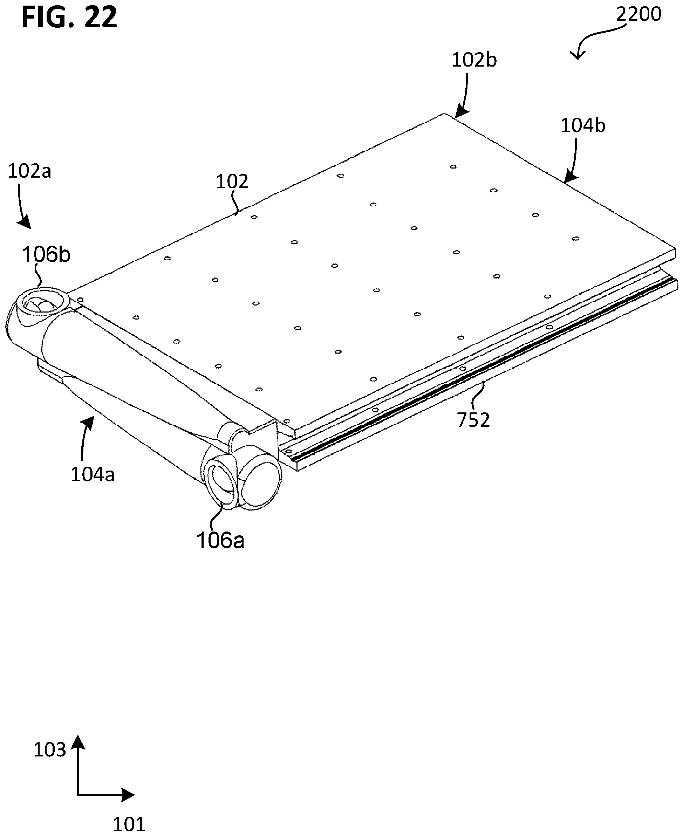

**Fig.22** veranschaulicht ein Temperierkörpergehäuse 100 gemäß verschiedenen Ausführungsformen 2200 in einer schematischen Perspektivansicht. Das Temperierkörpergehäuse weist auf: einen Gehäusemittelteil 102, eine erste Gehäuseendkappe 104a und eine zweite Gehäuseendkappe 104b (in der Ansicht verdeckt). Wie dargestellt muss die zweite Gehäuseendkappe 104b nicht notwendigerweise einen Hohlraum aufweisen, z.B. wenn diese keinen Fluidanschluss aufweist. Die zweite Gehäuseendkappe 104b kann beispielsweise eine Platte aufweisen oder daraus gebildet sein, welche die zweite Seite 102b des Gehäusemittelteils 102 verschließt (vgl. beispielsweise

Fig.28). Allgemeiner gesprochen kann die zweite Gehäuseendkappe 104b beispielsweise einen oder mehr als einen Stopfen aufweisen oder daraus gebildet sein, welcher die zweite Seite 102b des Gehäusemittelteils 102 (z.B. fluiddicht) verschließen kann.

Beispielsweise kann die zweite Gehäuseendkappe 104b (z.B. der Stopfen) mit dem Gehäusemittelteil 102 verschweißt oder verklebt sein.

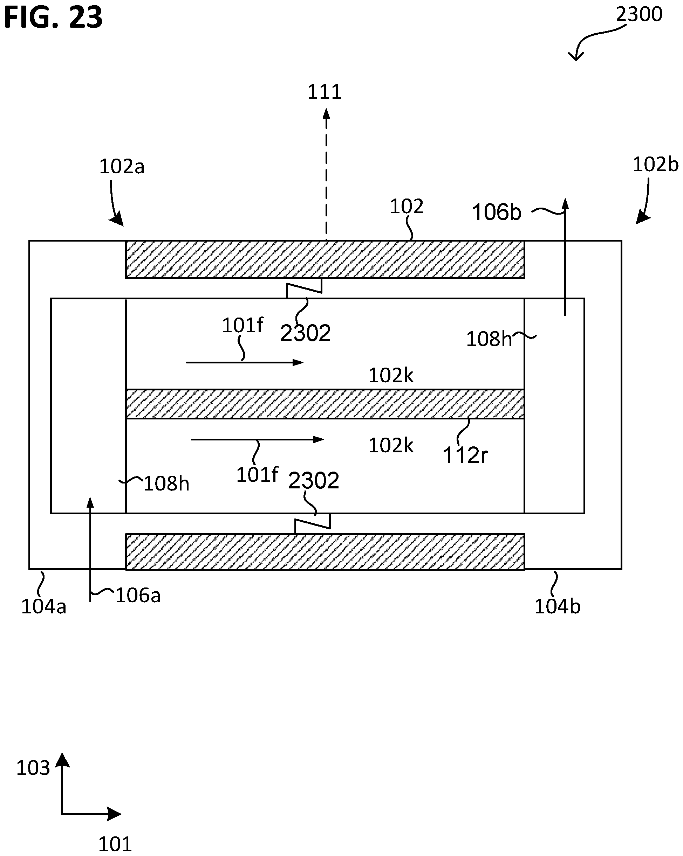

**Fig.23** veranschaulicht ein Temperierkörpergehäuse 100 gemäß verschiedenen Ausführungsformen 2300 in einer schematischen Draufsicht oder Querschnittsansicht. Wie vorstehend erwähnt, können zwei oder mehr Gehäusebestandteile formschlüssig miteinander verbunden sein, z.B. mittels Schraubens, Nietens, Ineinandergreifens, z.B. mittels ineinander rastender Elemente (auch als Rastelemente bezeichnet) und/oder mittels anderer Formschlusselemente. Alternativ oder zusätzlich können zwei oder mehr Gehäusebestandteile stoffschlüssig, z.B. durch Kleben, Verschweißen, Verlöten, Umspritzen mit Kunststoff, Reibverschweißen.

Wie dargestellt können die zwei Gehäuseendkappen 104a, 104b formschlüssig verbunden sein mittels Rastelementen 2302 als beispielhafte Formschlusselemente. Es kann verstanden werden, dass alternativ oder zusätzlich zu den Rastelementen 2302 auch andere Formschlusselemente verwendet werden können, wie beispielsweise Schrauben oder Nieten, und/oder eine Stoffschluss. Die Formschlusselemente stellen bereit, dass die zwei Gehäuseendkappen 104a, 104b lösbar miteinander und/oder mit dem Gehäusemittelteil 102 verbunden sind. Die Formschlusselemente 2302 können beispielsweise eingerichtet sein, die Verbindung zerstörungsfrei und/oder reversibel herzustellen und/oder aufzuheben.

Wie dargestellt, können die zwei Gehäuseendkappen 104a, 104b (z.B. deren Formschlusselemente 2302) in der Gehäusemittelteil 102 hinein erstreckt sein. Dies erleichtert die lösbare Verbindung. Dasselbe kann in Analogie gelten, wenn die Formschlusselemente 2302 außerhalb des Gehäusemittelteils 102 angeordnet sind.

Allgemeiner gesprochen kann eine oder mehr als eine Gehäuseendkappe der zwei Gehäuseendkappen 104a, 104b in den Gehäusemittelteil 102 hinein oder durch dieses hindurch erstreckt sein.

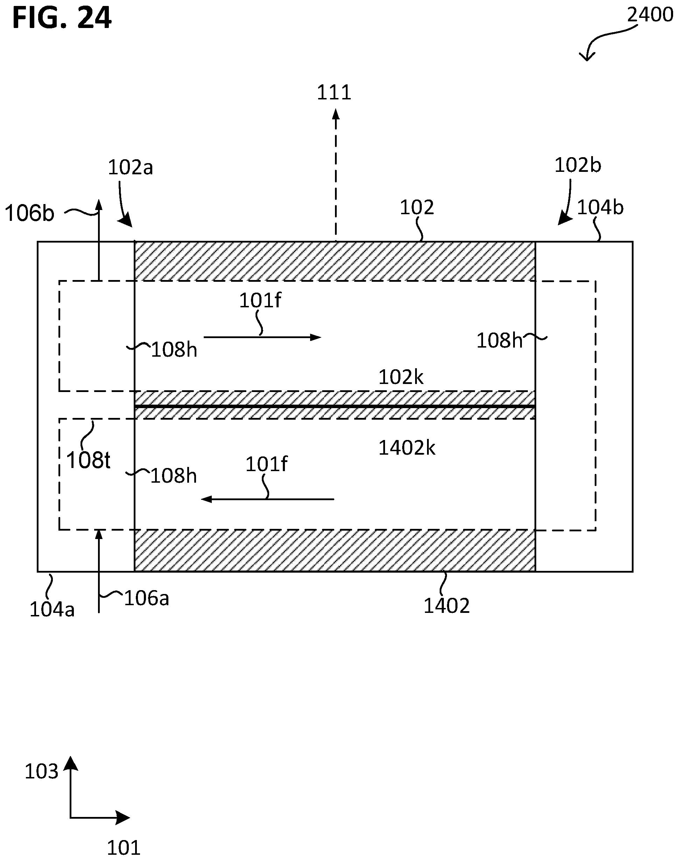

**Fig.24** veranschaulicht ein Temperierkörpergehäuse 100 gemäß verschiedenen Ausführungsformen 2400 in einer schematischen Draufsicht oder Querschnittsansicht. Das Temperierkörpergehäuse weist auf: einen ersten monolithischen Gehäusemittelteil 102, welcher von einem oder mehr als einem ersten Fluidkanal 102k durchdrungen ist, und einen zweiten monolithischen Gehäusemittelteil 1402 (auch als zusätzlicher Gehäusemittelteil bezeichnet), welcher von einem oder mehr als einem zweiten Fluidkanal 1402k durchdrungen ist, die erste Gehäuseendkappe 104a und die zweite Gehäuseendkappe 104b. Die erste Gehäuseendkappe 104a kann den ersten Fluidanschluss 106a aufweisen. Entweder kann die erste Gehäusekappe 104a (wie dargestellt) oder es kann die zweite Gehäuseendkappe 104b den zweiten Fluidanschluss 106b aufweisen. Der erste Fluidanschluss 106a und der zweite Fluidanschluss 106b können mittels des einen oder mehr als einen ersten Fluidkanals 102k und/oder mittels des einen oder mehr als einen zweiten Fluidkanals 1402k fluidleitend miteinander verbunden sein. Beispielsweise kann der Strömungspfad 101f von dem ersten Fluidanschluss 106a durch den einen oder mehr als einen ersten Fluidkanal 102k hindurch, danach oder parallel dazu durch den einen oder mehr als einen zweiten Fluidkanal 1402k hindurch, zu dem zweiten Fluidanschluss 106b führen.

Allgemeiner gesprochen kann das Temperierkörpergehäuse 100 den Gehäusemittelteil 102 und zusätzlich ein oder mehr als ein optionales Gehäusemittelteil 1402 aufweisen, welche mittels der ersten Gehäuseendkappe 104a und/oder mittels der zweiten Gehäuseendkappe 104b miteinander gekuppelt sind und/oder miteinander fluidleitend gekoppelt sind. Beispielsweise können der Gehäusemittelteil 102 und jedes zusätzliche Gehäusemittelteil 1402 auf ihrer ersten Seite 102a gemeinsam mittels der ersten Gehäuseendkappe 104a abgedeckt werden und auf ihrer zweiten Seite 102b gemeinsam mittels der zweiten Gehäuseendkappe 104b abgedeckt werden.

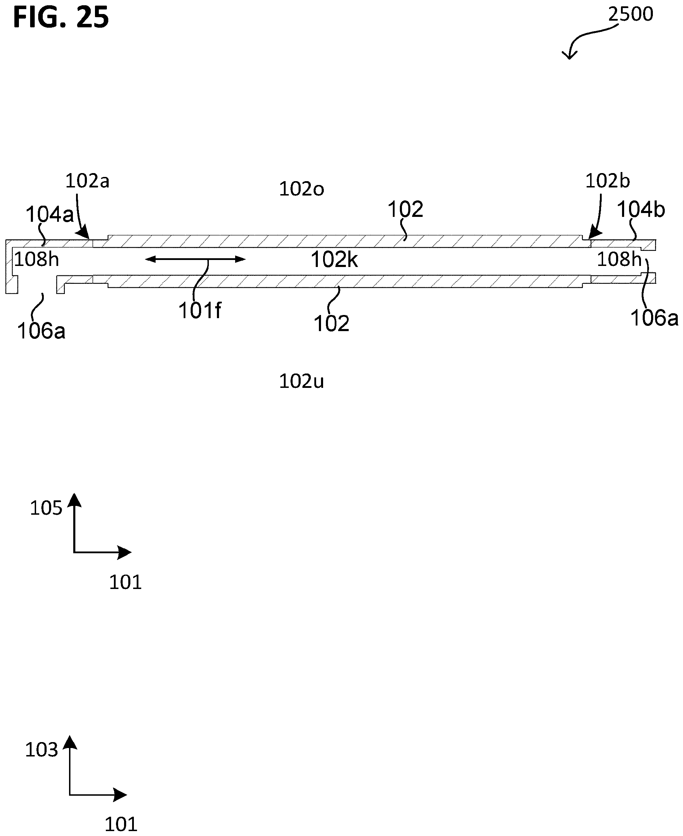

**Fig.25** veranschaulicht ein Temperierkörpergehäuse 100 gemäß verschiedenen Ausführungsformen 2500 in einer schematischen Querschnittsansicht. Das Gehäusemittelteil kann monolithisch sein (oder in verschiedenen hierin beschriebenen Vergleichsbeispielen mehrteilig). Wie dargestellt, kann der Hohlraum 108h jeder Gehäuseendkappe 104a, 104b an jeden Fluidkanal 102k angrenzen, z.B. diesen fortsetzend.

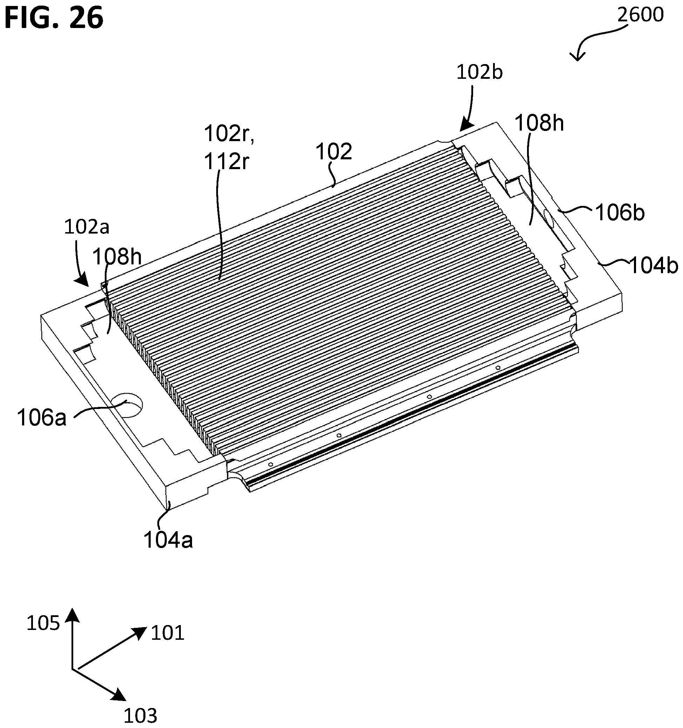

**Fig.26** veranschaulicht ein Temperierkörpergehäuse 100 gemäß verschiedenen Ausführungsformen 2600 in einer schematischen Perspektivansicht. Wie dargestellt, können mehrere Temperierrippen 102r, 112r (ersten Typs oder zweiten Typs) parallel zueinander erstreckt sein von der ersten Seite zu der zweiten Seite. Die Temperierrippen 102r, 112r können beispielsweise kammförmig ausgebildet sein.

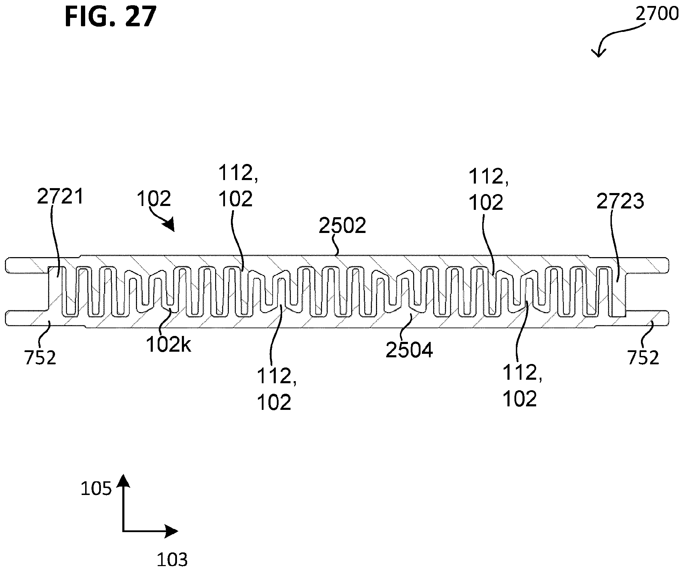

**Fig.27** veranschaulicht ein Temperierkörpergehäuse gemäß einem Vergleichsbeispiel 2700, welches nicht die Erfindung repräsentiert, in einer schematischen

Querschnittsansicht (z.B. mit Blickrichtung entlang der Strömungsrichtung). Das Vergleichsbeispiel veranschaulicht Aspekte der Temperierrippen 102r, 112r. Das Temperierkörpergehäuse kann in diesem Vergleichsbeispiel einen Gehäusemittelteil 102 aufweisen, welcher mehrteilig ist (auch als mehrteiliger Gehäusemittelteil 102 bezeichnet), d.h. welcher mehrere separate Bestandteile 2502, 2504 aufweist. Jeder der Bestandteile 2502, 2504 (auch als Gehäusemittelteil-Bestandteile bezeichnet) kann eine oder mehr als eine Temperierrippe 102r, 112r (ersten Typs oder zweiten Typs) aufweisen.

Beispielsweise kann der erste Gehäusemittelteil-Bestandteil 2502 als Deckel und der zweite Gehäusemittelteil-Bestandteil 2502 als Wanne ausgebildet sein. Alternativ oder zusätzlich können beide Gehäusemittelteil-Bestandteile 2502, 2504 strangförmig sein, z.B. sich in ihrer Form und/oder ihrem Profil voneinander unterscheidend.

Alternativ können beide Gehäusemittelteil-Bestandteile dieselbe Form und/oder dasselbe Profil aufweisen (und z.B. beide strangförmig sein). Dies erreicht, dass der Aufbau des Gehäusemittelteils 102 vereinfacht wird. Dann kann beispielsweise das erste Gehäusemittelteil-Bestandteil 2502 die rechte Außenwand 2723 des Gehäusemittelteils 102 bereitstellen und das zweite Gehäusemittelteil-Bestandteil 2504 kann die linke Außenwand 2721 des Gehäusemittelteils 102 bereitstellen. Zwischen den Außenwänden 2721, 2723 kann der eine oder mehr als eine Fluidkanal 102k angeordnet sein.

Jeder der zwei Gehäusemittelteil-Bestandteile 2502, 2504 kann beispielsweise ein Strangpressprodukt sein, Aluminium aufweisen (oder daraus gebildet sein) und/oder Kunststoff aufweisen (oder daraus gebildet sein). Wie dargestellt, können die Temperierrippen 102r, 112r (ersten Typs oder zweiten Typs) ineinandergreifen. Mit anderen Worten kann eine Temperierrippe 102r, 112r des ersten Gehäusemittelteil-Bestandteils 2502 zwischen zwei Temperierrippen 102r, 112r des zweiten Gehäusemittelteil-Bestandteils 2504 greifen oder andersherum.

Wie dargestellt können einander unmittelbar benachbarte Temperierrippen 102r, 112r sich voneinander unterscheiden, z.B. in ihrer Form, ihrer Dicke, ihrer Breite und/oder ihrer Höhe.

**Fig.28** veranschaulicht ein Temperierkörpergehäuse 100 gemäß verschiedenen Ausführungsformen 2800 in einer schematischen Draufsicht oder Querschnittsansicht. Das Temperierkörpergehäuse 100 weist auf: einen monolithischen Gehäusemittelteil 102, eine erste Gehäuseendkappe 104a und eine zweite Gehäuseendkappe 104b. In einem Vergleichsbeispiel weist das Temperierkörpergehäuse 100 auf: einen mehrteiligen Gehäusemittelteil 102, eine erste Gehäuseendkappe 104a und eine zweite Gehäuseendkappe 104b.

Die erste Gehäuseendkappe 104a weist den ersten Fluidanschluss 106a und den zweiten Fluidanschluss 106b (in der Ansicht nicht sichtbar) auf. Der Gehäusemittelteil 102 ist von mehreren Paaren 2802 Fluidkanälen 102k (aus zwei nebeneinander angeordneten Fluidkanälen 102k gebildet) durchdrungen, von denen jedes Paar Fluidkanäle 102k den ersten Fluidanschluss 106a und den zweiten Fluidanschluss 106b fluidleitend miteinander verbindet. Die Fluidkanäle 102k eines Paars können an der zweiten Gehäuseendkappe 104b (z.B. noch innerhalb des Gehäusemittelteils 102) miteinander verbunden sein. Dazu kann beispielsweise jede zweite Temperierrippe kürzer (d.h. zurückgezogen) ausgebildet sein oder eine Öffnung aufweisen. Dies erreicht, dass die zweite Gehäuseendkappe 104b eine planare Oberfläche aufweisen kann, welche jedes Paar 2802 abdeckt (z.B. an deren Verbindungsstelle).

Dieser Aufbau verringert die Komplexität des Temperierkörpergehäuse 100.

Das erfindungsgemäße Temperiergehäuse, welches im unabhängigen Anspruch 1 und den abhängigen Ansprüchen definiert ist, kann die in den nachfolgend genannten Beispielen erwähnten Merkmale zusätzlich enthalten.

Der Gehäusemittelteil weist zwei zueinander parallele Stirnseiten auf, zwischen denen der eine oder mehr als eine Fluidkanal erstreckt ist

Der Gehäusemittelteil weist zwei zueinander parallele Stirnseiten auf, welche profiliert und/oder strukturiert sind (z.B. eine Nut und/oder eine Rauprofilierung aufweisend).

Der Gehäusemittelteil weist größere Wärmeleitfähigkeit auf als die erste Gehäuseendkappe und/oder die zweite Gehäuseendkappe.

Der Gehäusemittelteil und die erste Gehäuseendkappe und/oder die zweite Gehäuseendkappe unterscheiden sich voneinander in ihrer chemischen Zusammensetzung und/oder in einem Gewichtsanteil von metallischem Material.

Bei dem Temperierkörpergehäuse nach Anspruch 6, wobei der Gehäusemittelteil im Wesentlichen denselben Ausdehnungskoeffizienten aufweist wie die erste Gehäuseendkappe und/oder wie die zweite Gehäuseendkappe ist eine relative Abweichung von weniger als 25%, 10% oder 5% zu verstehen.

Ein anderes Beispiel für weitergehende Modifikationen besteht darin, dass die erste Gehäuseendkappe und die zweite Gehäuseendkappe im Wesentlichen formgleich eingerichtet sind und/oder zueinander spiegelsymmetrisch sind.

In einem anderen Beispiel weist die erste Temperierrippe (z.B. Kühlrippe) eine erste Seitenfläche und eine zweite Seitenfläche (die sich beispielsweise gegenüberliegen) auf, welche an den Fluidkanal angrenzen, wobei die erste Seitenfläche eine größere Oberfläche und/oder größere Ausdehnung aufweist als die zweite Seitenfläche.

Beispielsweise kann auch die zweite Temperierrippe (z.B. Kühlrippe) eine erste Seitenfläche aufweisen, welche an einen der zwei einander unmittelbar benachbarten Fluidkanäle angrenzt, wobei die zweite Temperierrippe (z.B. Kühlrippe) eine zweite Seitenfläche aufweist, welche an den anderen der zwei einander unmittelbar benachbarten Fluidkanäle angrenzt, wobei die erste Seitenfläche eine größere Oberfläche und/oder größere Ausdehnung aufweist als die zweite Seitenfläche.

Ein anderes Beispiel ist ein Temperierkörpergehäuse, bei dem der Gehäusemittelteil mehrere Temperierrippen (z.B. Kühlrippen) aufweist, welche entlang derselben Richtung mit einer Ausdehnung in den einen oder mehr als einen Fluidkanal hinein erstreckt sind, wobei sich die mehreren Temperierrippen (z.B. Kühlrippen) in der Ausdehnung voneinander unterscheiden.

Weitere Beispile sind Temperierkörpergehäuse, bei denen sich die erste Gehäuseendkappe und die zweite Gehäuseendkappe voneinander unterscheiden in der Anzahl ihrer Fluidanschlüsse und/oder in der Ausrichtung ihrer Fluidanschlüsse oder bei denen die erste Gehäuseendkappe und die zweite Gehäuseendkappe dieselbe Anzahl Fluidanschlüsse und/oder dieselbe Ausrichtung ihrer Fluidanschlüsse aufweisen.

In einer anderen Variante besitzt das Temperierkörpergehäuse ein zusätzliches (z.B. monolithisches) Gehäusemittelteil, welches von einem oder mehr als einem zusätzlichen Fluidkanal durchdrungen ist, wobei der erste Fluidanschluss und der zweite Fluidanschluss mittels des einen oder mehr als einen zusätzlichen Fluidkanals fluidleitend miteinander verbunden sind.

## Patentansprüche

1. Temperierkörpergehäuse (100), aufweisend:
• einen monolithischen Gehäusemittelteil (102), welcher von einem oder mehr als einem Fluidkanal (102k) durchdrungen ist, wobei jeder Fluidkanal (102k) auf vier Seiten vollständig mittels entsprechender Wände begrenzt ist, welche monolithisch mit Außenwänden des Gehäusemittelteils (102) verbunden sind;
• eine erste Gehäuseendkappe (104a) und eine zweite Gehäuseendkappe (104b), zwischen denen der Gehäusemittelteil (102) angeordnet ist;
• wobei die erste Gehäuseendkappe (104a) einen ersten Fluidanschluss (106a) und entweder die erste Gehäusekappe (104a) oder die zweite Gehäuseendkappe (104b) einen zweiten Fluidanschluss (106b) aufweist;
• wobei der erste Fluidanschluss (106a) und der zweite Fluidanschluss (106b) mittels des einen oder mehr als einen Fluidkanals (102k) fluidleitend miteinander verbunden sind; und
• wobei der Gehäusemittelteil (102) eine erste Temperierrippe (102r) aufweist, welche in den Fluidkanal (102k) hinein erstreckt ist, wobei die erste Temperierrippe (102r) eine asymmetrische Kontur aufweist, und/oder
• wobei der Gehäusemittelteil (102) zwei einander unmittelbar benachbarte Fluidkanäle aufweist und ferner eine zweite Temperierrippe (112r) aufweist, welche die zwei einander benachbarten Fluidkanäle voneinander separiert, wobei die zweite Temperierrippe (112r) eine asymmetrische Kontur aufweist.

2. Temperierkörpergehäuse (100) gemäß Anspruch 1, wobei die erste Gehäuseendkappe (104a) und die zweite Gehäuseendkappe (104b) einen Kunststoff aufweisen oder aus dem Kunststoff gebildet sind.

3. Temperierkörpergehäuse (100) gemäß Anspruch 1 oder 2, wobei der Gehäusemittelteil (102) ein Strangpressprodukt aufweist oder aus einem Strangpressprodukt gebildet ist.

4. Temperierkörpergehäuse (100) gemäß einem der Ansprüche 1 bis 3, wobei der Gehäusemittelteil (102) ein Metall, eine Keramik oder ein Glas aufweist oder daraus gebildet ist.

5. Temperierkörpergehäuse (100) gemäß einem der Ansprüche 1 bis 4, ferner aufweisend:
eine Dichtung mittels welcher der Gehäusemittelteil (102) mit der ersten Gehäuseendkappe (104a) bzw.
der zweiten Gehäuseendkappe (104b) fluiddicht verbunden ist.

6. Temperierkörpergehäuse (100) gemäß einem der Ansprüche 1 bis 5, wobei der Gehäusemittelteil (102) im Wesentlichen denselben Ausdehnungskoeffizienten aufweist wie die erste Gehäuseendkappe (104a) und/oder wie die zweite Gehäuseendkappe (104b).

7. Temperierkörpergehäuse (100) gemäß einem der Ansprüche 1 bis 6, wobei der Gehäusemittelteil (102) mehrere Temperierrippen (102r, 112r) aufweist, welche entlang derselben Richtung mit einer Ausdehnung in den einen oder mehr als einen Fluidkanal (102k) hinein erstreckt sind, wobei sich die mehreren Temperierrippen (102r, 112r) in der Ausdehnung voneinander unterscheiden.

8. Temperierkörpergehäuse (100) gemäß einem der Ansprüche 1 bis 7, ferner aufweisend:
ein Wärmeleitmaterial (902), welches auf einer Wärmeleistungsaufnahmefläche des Gehäusemittelteils (102) angeordnet ist.

9. Temperierkörpergehäuse (100) gemäß Anspruch 8,
• wobei eine Wärmeleistungsaufnahme der Wärmeleistungsaufnahmefläche im Betrieb des Temperierkörpergehäuses (100) ein erstes Gefälle aufweist; und
• wobei ein thermischer Widerstand des Wärmeleitmaterials ein zweites Gefälle aufweist, welches entlang des Gefälles der Wärmeleistungsaufnahme gerichtet ist, so dass sich das erste Gefälle und das zweite Gefälle zumindest teilweise kompensieren.

10. Temperieranordnung (1200), aufweisend:
• ein Temperierkörpergehäuse (100) gemäß einem der Ansprüche 1 bis 9; und
• eine Fluidversorgung, welche mit den zwei Fluidanschlüssen des Temperierkörpergehäuses (100) gekoppelt und eingerichtet ist, einen Fluidstrom durch das Temperierkörpergehäuse (100) hindurch bereitzustellen.

11. Elektrische Vorrichtung (1300), aufweisend:
• ein elektrisches Bauteil (1202), und
• ein Temperierkörpergehäuse (100) gemäß einem der Ansprüche 1 bis 9, auf dem das elektrische Bauteil (1202) angeordnet ist.

## Claims

1. Temperature-control body housing (100), having:
• a monolithic housing middle part (102), which is penetrated by one or more than one fluid channel (102k), wherein each fluid channel (102k) is completely delimited on four sides by means of corresponding walls, which are monolithically connected to outer walls of the housing middle part (102);
• a first housing end cap (104a) and a second housing end cap (104b), between which the housing middle part (102) is arranged;
• wherein the first housing end cap (104a) has a first fluid connection (106a) and either the first housing cap (104a) or the second housing end cap (104b) has a second fluid connection (106b);
• wherein the first fluid connection (106a) and the second fluid connection (106b) are fluidically connected to one another by means of the one or more than one fluid channel (102k); and
• wherein the housing middle part (102) has a first temperature-control rib (102r), which extends into the fluid channel (102k), wherein the first temperature-control rib (102r) has an asymmetrical contour, and/or
• wherein the housing middle part (102) has two directly adjacent fluid channels and also has a second temperature-control rib (112r), which separates the two adjacent fluid channels from each other, wherein the second temperature-control rib (112r) has an asymmetrical contour.

2. Temperature-control body housing (100) according to Claim 1, wherein the first housing end cap (104a) and the second housing end cap (104b) comprise plastic or are formed from plastic.

3. Temperature-control body housing (100) according to Claim 1 or 2, wherein the housing middle part (102) comprises an extrusion product or is formed from an extrusion product.

4. Temperature-control body housing (100) according to one of Claims 1 to 3, wherein the housing middle part (102) comprises or is formed from a metal, a ceramic or a glass.

5. Temperature-control body housing (100) according to one of Claims 1 to 4, also having:
a seal by means of which the housing middle part (102) is connected to the first housing end cap (104a) and the second housing end cap (104b), respectively, in a fluid-tight manner.

6. Temperature-control body housing (100) according to one of Claims 1 to 5, wherein the housing middle part (102) has substantially the same coefficient of expansion as the first housing end cap (104a) and/or as the second housing end cap (104b).

7. Temperature-control body housing (100) according to one of Claims 1 to 6, wherein the housing middle part (102) has multiple temperature-control ribs (102r, 112r), which are made to extend along the same direction, with an extent into the one or more than one fluid channel (102k), wherein the multiple temperature-control ribs (102r, 112r) differ from one another in extent.

8. Temperature-control body housing (100) according to one of Claims 1 to 7, also comprising:
a heat conductive material (902), which is arranged on a heat output take-up surface of the housing middle part (102).

9. Temperature-control body housing (100) according to Claim 8,
• wherein a heat output take-up of the heat output take-up surface has a first gradient during operation of the temperature-control body housing (100); and
• wherein a thermal resistance of the heat conductive material has a second gradient, which is directed along the gradient of the heat output take-up such that the first gradient and the second gradient at least partially compensate each other.

10. Temperature-control assembly (1200), having:
• a temperature-control body housing (100) according to one of Claims 1 to 9; and
• a fluid supply, which is coupled to the two fluid connections of the temperature-control body housing (100) and configured to provide a fluid flow through the temperature-control body housing (100).

11. Electrical device (1300), having:
• an electrical component (1202), and
• a temperature-control body housing (100) according to one of Claims 1 to 9, on which the electrical component (1202) is arranged.

## Revendications

1. Boîtier de corps de régulation de température (100), comprenant :
• une partie de boîtier médiane monolithique (102) qui est traversée par un ou plusieurs conduits de fluide (102k), chaque conduit de fluide (102k) étant entièrement délimité sur quatre côtés par des parois correspondantes qui sont reliées de manière monolithique à des parois extérieures de la partie de boîtier médiane (102) ;
• un premier capuchon d'extrémité de boîtier (104a) et un deuxième capuchon d'extrémité de boîtier (104b) entre lesquels est disposée la partie de boîtier médiane (102) ;
• le premier capuchon d'extrémité de boîtier (104a) comportant un premier raccord de fluide (106a) et soit le premier capuchon de boîtier (104a) soit le deuxième capuchon d'extrémité de boîtier (104b) comportant un deuxième raccord de fluide (106b) ;
• le premier raccord de fluide (106a) et le deuxième raccord de fluide (106b) étant reliés l'un à l'autre de manière conductrice de fluide au moyen des un ou plusieurs conduits de fluide (102k) ; et
• la partie de boîtier médiane (102) comportant une première nervure de régulation de température (102r) qui s'étend jusque dans le conduit de fluide (102k), la première nervure de régulation de température (102r) présentant un contour asymétrique, et/ou
• la partie de boîtier médiane (102) comportant deux conduits de fluide directement adjacents l'un à l'autre et comportant également une deuxième nervure de régulation de température (112r) qui sépare les deux conduits de fluide adjacents l'un de l'autre, la deuxième nervure de régulation de température (112r) présentant un contour asymétrique.

2. Boîtier de corps de régulation de température (100) selon la revendication 1, le premier capuchon d'extrémité de boîtier (104a) et le deuxième capuchon d'extrémité de boîtier (104b) comportant une matière synthétique ou étant formés à partir de la matière synthétique.

3. Boîtier de corps de régulation de température (100) selon la revendication 1 ou 2, la partie de boîtier médiane (102) comportant un produit extrudé ou étant formée à partir d'un produit extrudé.

4. Boîtier de corps de régulation de température (100) selon l'une des revendications 1 à 3, la partie de boîtier médiane (102) comportant un métal, une céramique ou un verre ou étant formée à partir de ceux-ci.

5. Boîtier de corps de régulation de température (100) selon l'une des revendications 1 à 4, comportant en outre :
une garniture d'étanchéité au moyen duquel la partie de boîtier médiane (102) est reliée de manière étanche aux fluides au premier capuchon d'extrémité de boîtier (104a) ou au deuxième capuchon d'extrémité de boîtier (104b).

6. Boîtier de corps de régulation de température (100) selon l'une des revendications 1 à 5, la partie de boîtier médiane (102) ayant sensiblement le même coefficient de dilatation que le premier capuchon d'extrémité de boîtier (104a) et/ou que le deuxième capuchon d'extrémité de boîtier (104b).

7. Boîtier de corps de régulation de température (100) selon l'une des revendications 1 à 6, la partie de boîtier médiane (102) comportant une pluralité de nervures de régulation de température (102r, 112r) qui s'étendent dans la même direction avec une extension dans les un ou plusieurs conduits de fluide (102k), la pluralité de nervures de régulation de température (102r, 112r) se différenciant les unes des autres en termes d'extension.

8. Boîtier de corps de régulation de température (100) selon l'une des revendications 1 à 7, comportant en outre :
un matériau thermoconducteur (902) qui est disposé sur une surface d'absorption d'énergie thermique de la partie de boîtier médiane (102).

9. Boîtier de corps de régulation de température (100) selon la revendication 8,
• l'absorption d'énergie thermique par la surface d'absorption d'énergie thermique présentant un premier gradient pendant le fonctionnement du boîtier de corps de régulation de température (100) ; et
• une résistance thermique du matériau thermoconducteur présentant un deuxième gradient qui est dirigé le long du gradient de l'absorption d'énergie thermique de sorte que le premier gradient et le deuxième gradient se compensent au moins partiellement.

10. Ensemble de régulation de température (1200), comportant :
• un boîtier de corps de régulation de température (100) selon l'une des revendications 1 à 9 ; et
• une alimentation en fluide qui est accouplée aux deux raccords de fluide du boîtier de corps de régulation de température (100) et qui est conçue pour fournir un flux de fluide à travers le boîtier de corps de régulation de température (100).

11. Dispositif électrique (1300), comportant :
• un composant électrique (1202), et
• un boîtier de corps de régulation de température (100) selon l'une des revendications 1 à 9 sur lequel le composant électrique (1202) est disposé.
